# EUROPEAN PATENT APPLICATION

(11) **EP 1 693 482 A1**
(43) Date of publication of application: **23.08.2006**
(21) Application number: 04820262.6
(22) Date of filing: 09.12.2004
(51) Int. Cl.: C23C 14/08, C23C 14/34, B01J 21/06, C03C 17/245

(54) **Ti OXIDE FILM EXHIBITING PHOTOCATALYTIC ACTIVITY UPON VISIBLE LIGHT IRRADIATION AND PROCESS FOR PRODUCING THE SAME**

(30) Priority: 09.12.2003 JP 2003410804
(71) Applicant: ASAHI GLASS COMPANY LTD., Tokyo 100-8405 (JP)
(72) Inventor: FUKAWAM, Makoto, c/o Asahi Glass Company, Limited, Yokohama-shi, Kanagawa 221-8755 (JP); ODAKA, Hidefumi, c/o Asahi Glass Company, Limited, Yokohama-shi, Kanagawa 221-8755 (JP); OYAMA, Takuji, c/o Asahi Glass Company, Limited, Yokohama-shi, Kanagawa 221-8755 (JP); MITSUI, Akira, c/o Asahi Glass Company, Limited, Yokohama-shi, Kanagawa 221-8755 (JP)
(74) Representative: Müller-Boré & Partner Patentanwälte
(86) International application number: PCT/JP2004/018376
(87) International publication number: WO 2005/056870

(57) **Abstract**

To provide a visible light responsible Ti oxide film which has hydrophilicity and antifogging property and is excellent in transparency and which has an ability to decompose gas by UV radiation, and a process for its production, as well as a Ti oxide film-coated substrate.

A Ti oxide film formed on a substrate, **characterized in that** when a voltage is applied to the Ti oxide film while the Ti oxide film is irradiated with light of a xenon lamp having a luminance of 100 mW/cm² and having ultraviolet light of less than 400 nm cutoff, the electric current value is at least 1,000 times the electric current value when the same voltage as said voltage is applied to the Ti oxide film in a dark place.

## Description

### TECHNICAL FIELD

The present invention relates to a Ti oxide film having visible light-responsive photocatalytic activities to be used mainly for antifogging glass for automobiles, and a process for its production.

### BACKGROUND ART

In recent years, development of applied products utilizing a photocatalytic function shown by e.g. titanium oxide, has been active. For example, development of commercial products is being studied wherein a photocatalytic performance is utilized for the purpose of antifouling (particularly for removal of an organic substance), antibacteria or cleaning air by decomposing an organic substance by irradiation with light.

Further, in recent years, it has been found that a photocatalytic material may be formed as a thin film on a transparent substrate such as a glass substrate, and the photocatalytic performance of the formed film may be utilized to decompose an organic substance thereby to carry out antifouling (removal of an organic substance), antibacteria or cleaning air, and its application to glass for buildings or glass for vehicles such as automobiles, utilizing such a photocatalytic performance, is expected.

However, usual titanium oxide requires ultraviolet rays of less than 380 nm as excitation light. In sunlight or artificial light as a usual excitation light source, rather than ultraviolet rays, visible light rays contain a larger amount of photon, and accordingly, with usual titanium oxide, the major portion of the excitation light can not be utilized, such being not desirable also from the viewpoint of the efficiency.

In recent years, a research for visible light-responsive photocatalysts has been actively conducted which can be utilized at a place where ultraviolet light can not be used. For example, it is disclosed that a visible light responsive photocatalyst can be obtained by a method wherein a non-crystalline or incompletely crystalline titanium oxide and/or titanium hydroxide is heated in an atmosphere of ammonia or its derivative, and the heating is completed at such a timing that the light absorption at a wavelength of 450 nm of the formed material is larger than the light absorption at 450 nm of the raw material titanium oxide compound (e.g. Patent Documents 1 and 2). However, in such a method, heating is carried out in an atmosphere of ammonia and not in the atmospheric air. Accordingly, a heating furnace capable of practically controlling the atmosphere is required, and there has been a problem such that an installation cost is required also for preventing leakage of the ammonia gas. Further, with respect to the heating temperature condition, a temperature of from 250°C to 550°C is disclosed, but there is no disclosure of a temperature range exceeding 550°C.

In a process for producing glass for vehicles such as automobiles, it is common to carry out tempering and bending of a glass substrate. In many cases, such tempering and bending of a glass substrate is carried out at a maximum temperature of from 600°C to 700°C and in the atmospheric air. Therefore, with the visible light-responsive photocatalyst disclosed in Patent Document 1 or 2, it was possible that if titanium oxide on the glass substrate was heated under the temperature conditions for tempering and bending, the light absorption in a visible light range tended to be small, and no sufficient visible light response was obtained. Accordingly, it was hardly applicable to vehicles, and its application was rather limited. Further, a step for forming the material into a thin film was required, thus leading to a possible increase of the installation cost.

Further, as a method which does not require heating in an atmosphere of ammonia, a method for producing a titanium oxide type photocatalyst, is disclosed wherein the O/Ti atomic number ratio at a layer deeper than the surface of a photocatalyst film is smaller than the O/Ti atomic number ratio at the surface (e.g. Patent Document 3). The photocatalyst in this reference is one obtainable by heating a complex of a titanium alkoxide with a chelating agent such as acetylacetone in an oxidizing atmosphere preferably at a temperature of from 400 to 700°C. However, it has had a problem from the viewpoint of the production such that a production cost results from the use of the titanium alkoxide and the chelating agent, and it is difficult to control the atomic number ratio of O/Ti at the surface and the interior. For example, it is disclosed that the temperature should not be too high, since if the heating temperature is made high, the interior of the photocatalyst film will also be completely oxidized. However, the description of Examples is limited to 500°C, and there has been a problem that in a step requiring tempering and bending of a glass substrate like a glass for vehicles, the production conditions will be extremely limited to control the atomic number ratio of O/Ti at the surface and the interior, by such a heating temperature.

Further, as a method for obtaining a visible light-responsive photocatalyst, a method such as doping of an anion such as N, S or C, doping of a cation such as Cr, V or Ni or co-doping of an anion and a cation, to titanium oxide, is disclosed (e.g. Patent Documents 4 and 5 disclosing a case of N doping, Patent Document 6 disclosing a case of anion doping to titanium oxide by sputtering). In these references, it is disclosed that after forming a film by e.g. RF magnetron sputtering by using Ti, TiO₂ or TiS₂ as the target, heating treatment is carried out at about 550°C for 2 hours, whereby a visible light-responsive photocatalyst can be obtained. Such a production method has had a limitation such that when a ceramic target such as a TiO₂ target or a TiS₂ target is employed, film formation or deposition is possible only by RF sputtering. RF sputtering requires a production installation which is expensive as compared with a direct current (DC) sputtering installation, and its deposition rate is low, whereby it has a problem that the production cost is substantial. Further, in a case where Ti is employed as the target, DC sputtering is possible, but a method of forming an oxynitride such as TiON into a film by reactive sputtering likewise has had a problem that the deposition rate is low.

Further, it is disclosed that TiO₂ formed into a film by sputtering, is heated by a lamp in an NH₃ atmosphere or in an atmosphere containing NH₃, whereby a visible light-responsive photocatalyst composed of TiON, is obtainable (e.g. Patent Document 7). However, in such a method, an NH₃ atmosphere is required, and heating in the atmospheric air can not be carried out. Accordingly, its application to a glass tempering/bending step is considered to be impossible, and thus, the method has had a problem that the application is rather limited.

Further, as an example of cation doping, it is disclosed that a visible light-responsive photocatalyst can be obtained by carrying out ion implantation of a metal element such as Cr or V to an anatase type TiO₂, followed by heat treatment (e.g. Patent Document 8). However, this method employs ion implantation and thus has had a problem such that the installation cost is substantial, or in the case of a thin film, it takes time for its production to secure uniformity in the film plane.

As a method for forming a film made of titanium oxide showing a photocatalytic function, a wet method has been mainly studied (e.g. Patent Document 9). Such a wet method may, for example, be a method wherein fine particles of titanium oxide are fixed by an organic or inorganic binder, or a method wherein the film is formed by a sol-gel method from a titanium organic metal solution. By such a wet method, a film made of titanium oxide showing a photocatalytic function can be formed by applying a liquid to a substrate having a small area such as a tile. However, in a case where a liquid is applied to a substrate having a large area such as a window glass, the thickness of the film formed has been non-uniform, and the abrasion resistance of the film formed has been inadequate. Further, it has been very difficult to store the coating liquid in a constant state.

In order to solve the above-mentioned problems in the wet method, a method has been disclosed in which a Ti oxide film having a photocatalytic function is formed by vacuum evaporation (e.g. Patent Document 10). In this reference, it is disclosed that a Si oxide film is overcoated on the Ti oxide film, whereby the hydrophilicity-holding time in a dark place can be substantially improved. However, the vacuum evaporation method has had a drawback that when a Ti oxide film is formed on a substrate having a large area, it is difficult to maintain the uniformity in the thickness of the film, like in the wet method. Especially in a case where a Ti oxide film is to be formed on a glass substrate to be used e.g. a glass for buildings or glass for vehicles, it is required that the uniformity of the film thickness, the transparency, the optical characteristics, the appearance, etc. be good, and it has been difficult to satisfy such requirements by the vacuum evaporation method.

On the other hand, a DC sputtering method employing a metal target to be used for the production of heat reflecting glass for buildings or vehicles, has merits such that a film having a uniform thickness can be formed easily on a substrate having a large area, and the adhesion of the formed film to the substrate is also excellent, and no special care is required for the storage of the sputtering target (e.g. Patent Document 11). However, in a usual DC sputtering method employing a titanium metal target, it is required to incorporate an oxidizing gas such as oxygen into the sputtering gas, and thus, there has been a drawback that the deposition rate for the Ti oxide film tends to be very low.

In order to solve the above problem, a method has been disclosed wherein using control by plasma emission or a dual magnetron sputtering apparatus, titanium oxide is formed into a film by means of a titanium or titanium oxide target, followed by heat treatment in the atmospheric air to obtain a photocatalytic titanium oxide (e.g. Patent Document 12 or 13). However, in this method, titanium oxide after formed into a film exhibits no substantial absorption at a visible light range, or even when it exhibits an absorption, such a light absorption in a visible light range will readily be extinguished by the atmospheric air annealing. Namely, although it is disclosed to have a photocatalytic activity responsive to ultraviolet light, there is no disclosure to indicate a photocatalytic activity responsive to visual light.
Patent Document 1: JP-A-2002-255555
Patent Document 2: JP-A-2002-331225
Patent Document 3: JP-A-10-146530
Patent Document 4: WO01/010553
Patent Document 5: JP-A-2001-207082
Patent Document 6: JP-A-2001-205103
Patent Document 7: JP-A-2003-40621
Patent Document 8: JP-A-9-262482
Patent Document 9: Japanese Patent No. 2,865,065
Patent Document 10: JP-A-2000-53449
Patent Document 11: JP-A-10-289165
Patent Document 12: JP-A-2003-117404
Patent Document 13: JP-A-2003-49265
Patent Document 14: JP-A-2003-117406
Patent Document 15: JP-A-8-158048
Patent Document 16: JP-A-2003-293119

### DISCLOSURE OF THE INVENTION

### OBJECT TO BE ACCOMPLISHED BY THE INVENTION

It is an object of the present invention to provide a Ti oxide film which has hydrophilicity and antifogging property by a visible light-responsive photocatalyst and is excellent in transparency and which has an ability to decompose gas; a substrate provided with such a Ti oxide film; and a process for producing such a Ti oxide film.

### MEANS TO ACCOMPLISH THE OBJECT

The present invention provides a Ti oxide film formed on a substrate, characterized in that when a voltage is applied to the Ti oxide film while the Ti oxide film is irradiated with light of a xenon lamp having a luminance of 100 mW/cm² and having ultraviolet light of less than 400 nm cutoff, the electric current value is at least 1,000 times the electric current value when the same voltage as said voltage is applied to the Ti oxide film in a dark place; and a Ti oxide film formed on a substrate, characterized in that the Ti oxide film has a crystal structure of anatase type, the surface layer of the Ti oxide film is TiO₂, the interior of the Ti oxide film is TiOₓ, and the total of contents of titanium, nitrogen and oxygen in the Ti oxide film is at least 99.0 mass%.

Further, the present invention provides the Ti oxide film, wherein an overcoating is formed on the Ti oxide film formed on the substrate; the Ti oxide film, wherein the thickness of the Ti oxide film is from 5 to 600 nm; the Ti oxide film, wherein the surface layer of the Ti oxide film is within a range of from 3 to 20 nm from the surface of the film; the Ti oxide film, wherein the absorbance of the Ti oxide film at a wavelength of 400 nm is from 0.3 to 40%; the Ti oxide film, wherein the total of contents of titanium and oxygen in the Ti oxide film is at least 99.0 mass%; the Ti oxide film, wherein an undercoating film is formed between the Ti oxide film and the substrate; the Ti oxide film, wherein the substrate is a glass substrate; the Ti oxide film, wherein the glass substrate is UV protection glass; and the Ti oxide film, wherein the Ti oxide film is formed on the inside surface of glass for vehicles.

Further, the present invention provides a Ti oxide film-coated substrate which is a substrate having the Ti oxide film formed on the surface.

The present invention provides a process for producing a Ti oxide film which comprises forming on a substrate a Ti oxide film by a sputtering method in an atmosphere of at least one gas selected from the group consisting of a rare gas, a nitrogen-containing gas and an oxygen-containing gas by means of a sputtering target composed of TiOₓ (1<x<2) wherein the total of contents of titanium and oxygen is at least 99.0 mass%, and then firing the Ti oxide film in the presence of oxygen at a temperature of from 400 to 750°C for from 1 to 28 minutes; the process for producing a Ti oxide film, wherein the pressure during the deposition of the Ti oxide film is from 1.5 to 6 Pa; and a process for producing a Ti oxide film which comprises forming a Ti oxide film on a substrate by a sputtering method in an atmosphere of at least one gas selected from the group consisting of a rare gas, a nitrogen-containing gas and an oxygen-containing gas by means of a sputtering target composed of TiOₓ (1<x<2) wherein the total of contents of titanium and oxygen is at least 99.0 mass%, then forming a Si oxide film by a sputtering method under a deposition pressure of at least 1.0 Pa, followed by firing in the presence of oxygen at a temperature of from 400 to 750°C for from 1 to 28 minutes.

### EFFECTS OF THE INVENTION

The Ti oxide film of the present invention has hydrophilicity and antifogging property by a visible light-responsive photocatalyst and is excellent in transparency. Further, it has an ability to decompose gas. Accordingly, it is useful as antifogging glass for vehicles such as automobiles. It is particularly preferred to provide the Ti oxide film of the present invention on the interior side of an antifogging glass for vehicles having a function to shield UV light, so that the antifogging property and hydrophilicity will be sufficiently obtained even if UV light is not sufficiently present.

### BRIEF DESCRIPTION OF DRAWINGS

Fig. 1 is a schematic cross-sectional view illustrating an embodiment of a Ti oxide film-coated glass substrate having a Ti oxide film formed on a glass substrate.
Fig. 2 is a schematic cross-sectional view illustrating an embodiment of a Ti oxide film-coated glass substrate having an overcoating formed on the Ti oxide film.
Fig. 3 is a schematic cross-sectional view illustrating an embodiment of a Ti oxide film-coated glass substrate having an undercoating film formed between the Ti oxide film and the substrate.

### MEANINGS OF SYMBOLS

10: Ti oxide film-coated glass substrate
20: Glass substrate
30: Ti oxide film
40: Overcoating
50: Undercoating

### BEST MODE FOR CARRYING OUT THE INVENTION

In a sputtering method, it is generally known that in a case where the portion of a target surface to be sputtered is in a metallic state, the number of atoms or molecules to be sputtered by impingement of one positive ion (hereinafter referred to as the sputtering yield) is large as compared with a case where it is in an oxidized state. For example, in the case of titanium, the sputtering yield of titanium metal is about 20 times the sputtering yield of titanium oxide. Accordingly, in a case where using a titanium metal target, a film of titanium oxide is formed by reactive sputtering to form a Ti oxide film, in order to improve the deposition rate, it becomes important to make the target surface to be in a metallic state or a partially oxidized state and to maintain a state where a Ti oxide film is obtainable on the substrate (the base material) i.e. an oxidizing state. Such adjustment is carried out by increasing or decreasing the amount of oxygen introduced depending upon the applied power or by controlling the concentration of oxygen in the sputtering gas in the film-forming chamber. However, while the state of the target surface changes in just a few seconds, it takes a time of a few tens seconds to change the amount of oxygen to be introduced. Accordingly, it is difficult to carry out the above adjustment accurately. In this specification, "the visible light region" means a wavelength range of from 400 to 780 nm.

On the other hand, if a sputtering target composed of TiOₓ (1<x<2) (hereinafter referred to simply as the TiOₓ target) is sputtered by using a rare gas such as argon as the sputtering gas, the target surface subjected to the sputtering becomes closer to titanium metal than TiOₓ. Accordingly, it has been found that the sputtering yield of TiOₓ can be about ten times the sputtering yield of titanium oxide. Namely, when the TiOₓ target is used for sputtering, it is possible to form a Ti oxide film at a deposition rate of about 10 times as compared with a case where titanium metal is used.

However, a Ti oxide film formed on a substrate by a sputtering method by using a TiOₓ target formed by a usual thermal spraying method, did not show a photocatalytic activity by light in a visible light range (hereinafter referred to as a visible light-responsive photocatalytic property). To find out the cause, an analysis of the composition of the TiOₓ target formed by the thermal spraying method, was carried out, and it was found that a very small amount of impurities other than oxygen and titanium elements were included in an amount of about 2.0 mass% in the TiOₓ target. Therefore, a sputtering target composed of TiOₓ wherein the total of contents of titanium and oxygen (hereinafter referred to as the TiOₓ purity) was at least 99.0 mass% (i.e. the above-mentioned small amount of impurities were less than 1.0 mass% of the entire target) (hereinafter referred to as a high purity TiOₓ target) was formed, and using such a high purity TiOₓ target, a Ti oxide film was formed by a sputtering method. However, the high purity Ti oxide film formed also did not show a visible light-responsive photocatalytic property.

Then, the thin film structure of the Ti oxide film immediately after the film formation was analyzed by an XRD (x-ray diffraction) analysis. As a result, it has been confirmed that the formed Ti oxide film was not of an anatase type crystal structure, but amorphous. It is generally known that a Ti oxide film having an anatase type crystal structure exhibits a photocatalytic function. Therefore, after formation of the Ti oxide film, firing was carried out in an attempt to recrystallize the film. As a result, it was confirmed by the XRD analysis that the film structure of the Ti oxide film was changed from amorphous to an anatase type crystal structure by recrystallization. However, the Ti oxide film after firing did not necessarily exhibit a visible light response property.

The present inventors have conducted a further research and have found that when the firing conditions after forming the Ti oxide film are adjusted to carry out firing at a high temperature in a short period of time, the film after the firing exhibits a visible light-responsive photocatalytic property.

Thus, the present inventors have found that when a Ti oxide film is formed by a sputtering method by using a highly pure TiOₓ target different from a conventional TiOₓ target, and then fired with certain specific atmosphere, temperature and time, a visible light-responsive photocatalytic property will be developed. Further, it has been found that with the Ti oxide film of the present invention, when a voltage is applied to the Ti oxide film while the Ti oxide is irradiated with light of a xenon lamp having a luminance of 100 mW/cm² and having ultraviolet light of less than 400 nm cutoff, the electric current value would be at least 1,000 times, preferably at least 5,000 times, at least 10,000 times or at least 50,000 times, particularly preferably at least 100,000 times the electric current value when the same voltage is applied to the Ti oxide film in a dark place. Here, with respect to light of a xenon lamp having a luminance of 100 mW/cm² as a whole, when ultraviolet light of less than 400 nm is cutoff, the luminance of visible light of the xenon lamp light is considered to become about 95 mW/cm². The Ti oxide film of the present invention is preferred in that even when irradiated with light in a visible light range, it is capable of sufficiently transporting the formed carrier to the surface thereby to provide a visible light-responsive photocatalytic property. Here, the luminance of the visible light is sufficient at a level of at least 30 mW/cm².

Usually, light of a xenon lamp is light having a wide wavelength range of from about 200 nm to a near infrared region and has a luminance of about 100 mW/cm² as a whole. However, by cutting off light of less than 400 nm by a filter or the like, the light of a xenon lamp becomes light having a wavelength range of from visual light of at least 400 nm to a near infrared region. When a voltage is applied while the Ti oxide film is irradiated with this light of from the visible light to the near infrared region, if Ti oxide film has a visible light-responsive photocatalytic property, it becomes possible to take out the carrier excited by light to the surface, whereby the electric current will be generated. On the other hand, when the Ti oxide film is disposed in a dark place (which is meant for a place wherein the luminance of light in a visible light region is negligible, such as a place where the luminance is less than 0.1 mW/cm²), even if a voltage is applied to the Ti oxide film, no light-responsive current will be generated.

It is possible to quantitatively estimate the visual light-responsive photocatalytic property of the Ti oxide film by taking a ratio (a light-responsive current ratio) of the electrical current value (the visual light-responsive current value) when irradiated with the above-mentioned light of from the visual light to the near infrared region to the electrical current value (the dark current value) when disposed in the dark place. The reason for taking the ratio is in consideration of the fact that titanium oxide is close to an intrinsic semiconductor. Namely, even in a case where the visible light-responsive electric current is high, if the electric current in a dark place is high, the function as an intrinsic semiconductor is considered to be inadequate. When the electric current value is to be measured, the voltage to be applied to the Ti oxide film is set to be 100 V. Here, it is necessary to measure the electric current value after confirming that when the voltage is increased from -100 V to 100 V, the electric current value is also increased in proportion thereto and after confirming that ohmic contact is secured. Further, it is preferred to carry out such measurement of the electric current value in vacuum, since it is thereby possible to prevent a change in the resistance value due to an influence of oxygen, water, organic substances, etc. adsorbed on the film surface.

Further, as mentioned above, various specific conditions are required in order to let the Ti oxide film develop the visible light-responsive photocatalytic property. For example, in order to let it develop the visible light-responsive photocatalytic property, it is necessary to employ an oxygen-deficient type TiOₓ target. Detailed mechanisms are not clearly understood as to why a film formed by using an oxygen-deficient type TiOₓ target exhibits a visible light-responsive photocatalytic property or as to why a film formed by using a metal Ti target shows no visible light-responsive photocatalytic property. However, when sputtering is carried out by using a TiOₓ target in a rare gas such as argon, although the target surface subjected to sputtering becomes close to titanium metal than TiOₓ, the target itself is sintered at an extremely high temperature of at least about 1,200°C, and thermally stabilized oxygen-deficient type TiOₓ particles are considered to be deposited on the substrate to constitute a Ti oxide film. Accordingly, it is considered that the state where the oxygen-deficient type TiOₓ is deposited, is also thermally stable.

Whereas, a titanium oxide film formed in an oxide mode in an oxidizing atmosphere in the presence of oxygen, etc. by using a metal Ti target, is considered to be in a state where thermally unstable TiOₓ is deposited, particularly in a state where the substrate is not heated. Namely, it is considered that by using a TiOₓ target for forming a film, the Ti oxide film will have thermally stable defects therein, and as a result, it becomes possible to form a Ti oxide film exhibiting absorption of visible light even after firing in the atmospheric air. In addition, it is considered that by firing the film in the presence of oxygen as will be described hereinafter, the film surface will be in the state of TiO₂, whereby recombination at the surface of an electron hole formed by the visible light absorption will be suppressed, and thus a visible light-responsive photocatalytic property will be developed.

Further, as another method for forming a film of titanium oxide, a method of employing a titanium oxide target is also available. However, this method is not preferable from the viewpoint of the productivity since the target has no electrical conductivity, and it is not possible to employ a DC sputtering method, i.e. production is possible only by a RF sputtering method. Further, when formed by means of a sputtering gas comprising a rare gas and oxygen gas, the titanium oxide film formed by using a titanium oxide target, is in the state of a TiO₂ film and has no visible light-responsive photocatalytic property. Further, in a case where a film is formed by sputtering by means of a sputtering gas composed solely of a rare gas, it may be an oxygen-deficient type to some extent, but it does not have a thermally stable defect and thus has no visible light-responsive photocatalytic property.

The high purity TiOₓ target to be used in the present invention may be formed by either a melting method or a sintering method. In a melting method, for example, a high purity titanium oxide powder or a mixture of a high purity titanium oxide powder and a high purity titanium powder, may be used as a raw material; by means of a plasma spraying apparatus, the raw material is made into a semi-molten state; and the semi-molten state raw material is deposited on a metal substrate to form a target layer which may be used directly as a sputtering target. In a sintering method, a high purity titanium oxide powder, or a mixture of a high purity titanium oxide powder and a high purity titanium powder, is sintered by hot pressing (high temperature high pressure pressing) in a non-oxidizing atmosphere, to form a target. In the present invention, it is preferred to form the target by means of a sintering method from such a viewpoint that the target can be used for a long time, a thick target can easily be formed, or impurities tend to be scarcely included during sintering as the sintering is carried out in a closed space i.e. in a mold. Further, in a thermal spraying method, a large amount of impurities such as Fe will be unavoidably contained, and a defect level attributable to e.g. Fe is likely to be formed in the Ti oxide film, and the photocatalytic function can hardly be obtainable. Accordingly, it is preferred to employ a sintering method.

In order to form a Ti oxide film showing a visible light-responsive photocatalytic property on a substrate, it is required that the TiOₓ purity of the TiOₓ target is at least 99.0 mass%. By making the titanium oxide powder and the titanium powder as the raw materials to be of high purity, it is possible to form a TiOₓ target wherein the TiOₓ purity is at least 99.0 mass%. The TiOₓ purity in the TiOₓ target is preferably at least 99.5 mass%, further preferably at least 99.9 mass% from the viewpoint of the visible light-responsive photocatalytic property of the Ti oxide film to be formed. By using such a high purity TiOₓ target, it becomes possible to form a Ti oxide film which readily exhibits a visible light-responsive photocatalytic property. Further, the total of contents of impurities other than titanium and oxygen in the TiOₓ target is preferably less than 1 mass%, more preferably less than 0.5 mass%, particularly preferably less than 0.1 mass%.

In the present invention, the sputtering method may, for example, be a direct current (DC) sputtering method, an alternate current (AC) sputtering method or a radio frequency (RF) sputtering method. The AC sputtering method may, for example, be a sputtering method wherein a negative voltage intermittently repeated at a frequency of from 100 Hz to 100 kHz is applied to the target, and the RF sputtering method may, for example, be a sputtering method wherein an alternate current power of at least 100 kHz is applied. From the viewpoint of the productivity, it is preferred to employ the DC sputtering method. By using the sputtering method, a film can be formed on a substrate having a larger area with good uniformity of the film thickness in the plane, and it is possible to form a film having a high purity, such being preferred with a view to satisfying the constituting requirements for the Ti oxide film of the present invention. Further, by using the sputtering method, the strength of the film can be increased, such being preferred in that the film can be used in an application where an abrasion resistance is required, such as an application to automobiles or buildings.

In order to form the Ti oxide film showing a visible light-responsive photocatalytic property at a high deposition rate, as the sputtering gas (the gas to be introduced during the deposition) at least one type of gas selected from the group consisting of a rare gas, a nitrogen-containing gas and an oxygen-containing gas is employed. As the rare gas, at least one type selected from the group consisting of Ar, He, Ne, Kr and Xe may be employed.

The nitrogen-containing gas may, for example, be nitrogen or NH₃. The content of the nitrogen-containing gas in the gas to be introduced during the deposition is preferably at least 3 vol%, particularly preferably at most 90 vol% with a view to improvement of the visual light-responsive photocatalytic property. Further, the content of nitrogen atoms in the film is preferably from 0.5 to 5 mass%. Further, in order to increase the doping amount of nitrogen, H₂O may be added to the sputtering gas. Further, an oxygen-containing gas may be added to the sputtering gas. The oxygen-containing gas may be at least one type selected from the group consisting of O₂, NO₂, NO, CO, O₃ and CO₂. The content of such an oxygen-containing gas in the sputtering gas is preferably small from the viewpoint of the deposition rate. However, it is considered that by having oxygen contained in the film to some extent, it is possible to minimize the damage by oxygen negative ions, whereby formation of a defect level will be suppressed, and crystallinity is improved, whereby the visible light-responsive photocatalytic property is improved. Accordingly, it is preferred that oxygen is contained in the sputtering gas to some extent, and the content of the oxygen-containing gas in the sputtering gas is preferably from 1 to 10 mass%, from the viewpoint of the deposition rate.

The residual gas pressure immediately before deposition of the Ti oxide film should better be low for such a reason that a level in the band gap will be formed by an influence of water, and is preferably at most 1×10⁻³ Pa. Further, the discharge power density for deposition of the Ti oxide film is preferably from 0.007 to 8.6 W/cm² from the viewpoint of the deposition rate and from such a viewpoint that the ion damage will be reduced and the film quality will be good. Further, in a case where nitrogen is contained in the sputtering gas, the discharge power density is preferably from 0.007 to 6.4 W/cm², whereby the damage due to nitrogen can be suppressed to the minimum level. Here, the discharge power density is a value obtained by dividing the discharge power by the area of the sputtering target.

The pressure during deposition of the Ti oxide film is from 1.5 to 6 Pa, preferably from 2 to 6 Pa from the viewpoint of the improvement of crystallinity of the film after firing and improvement of the film quality by reducing an ion damage due to negative ions or positive ions in the plasma. When the pressure is from 1.5 to 6 Pa, after firing, the film will have an anatase type crystal structure, whereby the film exhibits a visible light-responsive photocatalytic property, such being desirable.

After forming the Ti oxide film, it is preferred to fire it in the presence of oxygen at from 400 to 750°C for from 1 to 28 minutes, more preferably at from 500 to 750°C for from 1 to 28 minutes or from 600 to 700°C for from 1 to 28 minutes, further preferably at from 400 to 750°C for from 1 to 15 minutes, at from 500 to 750°C for from 1 to 15 minutes, or at from 600 to 700°C for from 1 to 15 minutes. If the temperature is lower than 400°C, the effect of firing can not be adequately obtained, and if it exceeds 750°C, the glass substrate is like to be softened, whereby the product quality will be impaired. The temperature is particularly preferably at least 500°C, whereby the visible light-responsive photocatalytic property will be highly developed. Further, if the time is less than 1 minute, no adequate effect of firing can be obtained, and if it exceeds 28 minutes, the visible light-responsive photocatalytic property tends to be hardly developed, such being undesirable. Further, if it exceeds 15 minutes, such being not so desirable, since the visible light-responsive photocatalytic property tends to be low. The reason for development of the visible light-responsive photocatalytic property is considered to be such that by the above firing, it is possible to oxidize only the surface layer of the Ti oxide film and to make only the surface layer to be a complete TiO₂ film while the interior of the Ti oxide film is maintained to be TiOₓ having oxygen-deficiency.

The mechanism for improvement of the visible light-responsive photocatalytic property by making the surface layer of the Ti oxide film to be a complete TiO₂ film, is not clearly understood. However, it is considered that as the surface layer of the Ti oxide film is made to be a TiO₂ film, the transport characteristics of an electron hole in the film surface will be improved, and an electron hole formed by absorption of visible light, is prevented from recombination at the surface layer made to be TiO₂, whereby the visible light-responsive photocatalytic property is improved. Further, from the results of measurement by the XRD analysis of the film, the peak of (101) or (004) is utilized as a peak showing the anatase type crystal structure. Further, when the Ti oxide film-coated glass of the present invention is used as glass for automobiles, it will be subjected to a step of bending the glass by heating. The present invention is excellent in that in the bending step, the above firing can also be carried out.

The surface layer of the Ti oxide film is meant for a range of from 3 to 20 nm, particularly from 3 to 10 nm, further particularly from 3 to 5 nm, from the surface of the film, although it depends also on the entire film thickness. When the above range is oxidized, such is considered to be sufficient for the improvement of the visible light-responsive photocatalytic property. Further, the surface layer of the Ti oxide film means a range of from 5 to 60% from the surface of the film, based on the entire film thickness. Further, the visible light-responsive photocatalytic property will be reduced by annealing in a nitrogen gas atmosphere after firing the film. This is considered to be attributable to disappearance of the surface oxidation at the film surface, and the surface oxidation at the film surface is considered to play a role for development of the visible light-responsive photocatalytic property. Further, even in a case where firing is carried out after forming an overcoating on the Ti oxide film, it is likewise possible to fire only the surface of the Ti oxide film, although it may depend also on the kind of the film or the film thickness.

In the presence of oxygen is meant for an atmosphere wherein oxygen is contained in an amount of at least 5 vol%, and in the atmospheric air is preferred from the viewpoint of the cost.

Patent Document 16 discloses a method for forming a photocatalytic-responsive Ti oxide film by using a high purity TiOₓ target, and it is disclosed that the post firing temperature is preferably from 200°C to 650°C for from 30 minutes to 2 hours. However, according to the results of a study conducted by the present inventors, it has been found that no visible light photocatalytic property will be developed by firing for a long time such as from 30 minutes to 2 hours. Namely, it is considered that by the firing at a high temperature for a long time, oxygen is rather likely to be withdrawn from the surface of the Ti oxide film, and the surface layer tends to be converted from TiO₂ to TiOₓ (1<x<2).

It is considered that when the interior of the Ti oxide film is made to be oxygen deficient, while the absorption at a visible light range will be improved, the transport characteristics of electron holes formed by light excitation in the film tend to decrease, whereby the visible light-responsive photocatalytic property rather tends to decrease. Accordingly, there is the most efficient absorption at a visible light range in order to develop the visible light-responsive photocatalytic property at the maximum level. For example, in the case of a Ti oxide film having a thickness of 50 nm, the absorption at a wavelength of 400 nm is from 0.3 to 40%, preferably from 0.3 to 5%, more preferably from 0.3 to 2%. By adjusting the absorption at a level of from 0.3 to 40%, the balance between the amount of electron-hole pairs formed under excitation by visible light and the electron-hole transport characteristics by minimizing the number of defects will be optimum, whereby it becomes possible to develop the visible light-responsive photocatalytic property at the maximum level. It is considered that in the present invention, by forming a Ti oxide film by using a TiOₓ target, oxygen deficiency will be formed at the interior of the Ti oxide film (the portion inside of the film surface), and consequently the above-mentioned preferred absorption is attained. Here, the absorption is a value calculated by absorption (%)=100-(transmittance (%)+reflectance (%)).

In the present invention, by using the above-described TiOₓ target, a Ti oxide film is formed on a substrate. Here, the substrate is a carrier to form the Ti oxide film thereon, and specifically, a glass substrate, a ceramic substrate, ceramics (tiles, etc.) or exterior wall materials may, for example, be mentioned. From the viewpoint of versatility, a glass substrate excellent in transparency is usually used. The shape is not limited to a plate shape.

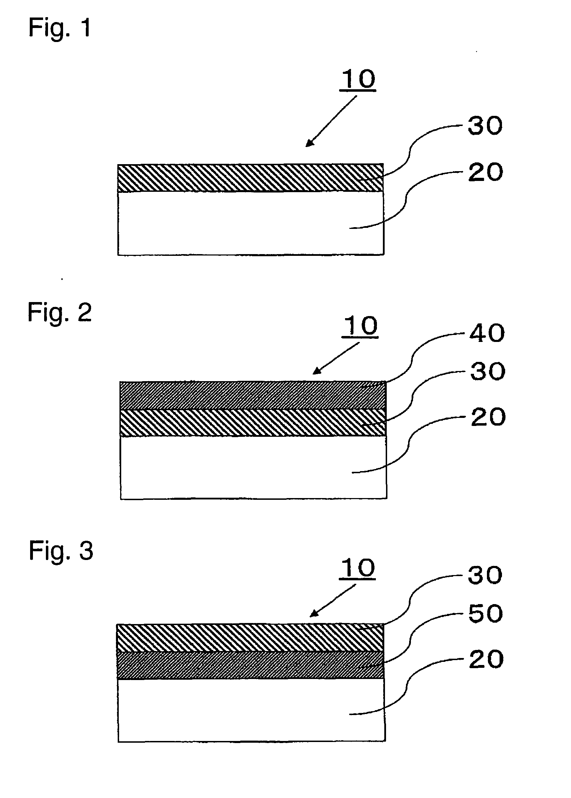

Fig. 1 is a preferred embodiment of the present invention and is one showing a schematic cross-sectional view of a Ti oxide film-coated glass substrate 10 having a Ti oxide film 30 formed on a glass substrate 20.

The thickness of the Ti oxide film 30 in the present invention is preferably from 5 to 600 nm, more preferably from 10 to 250 nm, particularly preferably from 50 to 250 nm, from the viewpoint of the visible light-responsive photocatalytic property, transparency and costs. Further, the visible light transmittance of the glass substrate having the Ti oxide film formed thereon is preferably at least 70% from the viewpoint of visibility.

Further, the total of contents of titanium, oxygen and nitrogen in the Ti oxide film is preferably at least 99.0 mass%, more preferably at least 99.5 mass%, particularly preferably at least 99.9 mass%, from the viewpoint of the visible light-responsive photocatalytic property. It is preferred to contain nitrogen, whereby the visible light-responsive photocatalytic property will be improved. The content of nitrogen in the Ti oxide film is preferably from 0.1 to 5 mass%, more preferably from 0.5 to 5 mass%, particularly preferably from 0.5 to 3 mass%. Here, for the purpose of developing the visible light-responsive photocatalytic property, it is not necessary for the Ti oxide film to contain nitrogen. In a case where the Ti oxide film contains no nitrogen, the TiOₓ purity in the Ti oxide film is preferably at least 99.0 mass% from such a viewpoint that it is possible to improve the carrier transport characteristics of electron holes, etc. formed in the film.

Further, as shown in Fig. 2, an overcoating 40 may be formed on the Ti oxide film. As such an overcoating, a low refractive index film is preferred, and in such a case, the thicknesses of the Ti oxide film and the overcoating are determined taking the low reflectance, durability, neutral color, etc. into consideration. The overcoating may, for example, be a Si oxide film. The thickness of the overcoating is preferably from 1 to 120 nm. If it is less than 1 nm, no adequate effect of the overcoating will be obtained, and if it exceeds 120 nm, the firing effects may not reach to the Ti oxide film, whereby the visible light-responsive photocatalytic property is likely to be low. The method for forming the overcoating is not particularly limited to a dry method such as a sputtering method or a wet method. In a case where the overcoating is to be formed by a sputtering method, it is preferred that the deposition pressure is adjusted to be at least 1.0 Pa, particularly preferably at least 1.5 Pa, since it is thereby possible to reduce the ion damage to the Ti oxide film during the deposition and thereby maintain a high visible light-responsive photocatalytic property of the Ti oxide film. In a case where a Si oxide film is to be formed by a sputtering method, it is possible to employ a method wherein a Si oxide film is formed by using a silicon target and an oxidizing gas as the sputtering gas, or a method wherein a Si oxide film is formed by using a Si oxide target and a rare gas as the sputtering gas.

Further, as shown in Fig. 3, an undercoating film 50 may be formed between the Ti oxide film 30 and the glass substrate 20. In a case where an alkali-containing glass is used as the glass substrate, the above undercoating film is preferably a film having an alkali barrier function (an alkali barrier film), and a Si oxide film, a Si nitride film or an Al nitride film may, for example, be mentioned. The thickness of the undercoating film is preferably from 10 to 150 nm. The method for forming the undercoating film is not particularly limited to a dry method such as a sputtering method or a wet method. In a case where a sputtering method is to be employed, a Si oxide film, a Si nitride film or an Al nitride film may be formed by a reactive sputtering method by using the corresponding metal target. Further, by forming an alkali barrier film, an intermediate refractive index film (refractive index=1.6 to 2.2) and a Ti oxide film sequentially from the substrate side, it is possible to form a visible light-responsive photocatalytic Ti oxide film-coated glass substrate having the transparency improved.

Further, by forming a Ti oxide film and a Si oxide film in this order from the substrate, it is also possible to make these films to be the undercoating film. By taking such a construction, it becomes possible to form a Ti oxide film-coated glass substrate having a low reflecting function or a high reflecting function at a near infrared region, by adjusting the thicknesses of the respective layers.

Further, it is preferred to adjust the thermal expansion coefficient of glass for the substrate and the thermal expansion coefficient of the Ti oxide film to be close to each other, whereby it is possible to suppress cracking or peeling of the film and deformation of the substrate during the post-heat treatment. The thermal expansion coefficient of glass is preferably from 3O×10⁻⁷ to 100×10⁻⁷/K in consideration of the fact that the thermal expansion coefficient of the Ti oxide film is substantially constant irrespective of the crystalline state.

The present invention is capable of providing also a Ti oxide film-coated substrate, particularly a Ti oxide film-coated glass substrate, having functions such as antifogging, hydrophilic, gas decomposing, antifouling, fungicidal, antibacterial and atmospheric air-cleaning functions imparted, characterized by using such a visible light-responsive photocatalyst. As such a Ti oxide film-coated glass substrate, glass for buildings, glass for vehicles or glass for various industrial uses may, for example, be mentioned. Further, it is particularly preferred to use it as an antifogging, hydrophilic glass substrate by laminating a Si oxide film on a Ti oxide film, for a reason such that the hydrophilic property can be maintained even in a dark place and a low reflecting property can be obtained. The antifouling or atmospheric air-cleaning function is evaluated by a rate at which the Ti oxide film decomposes organic substances by irradiation with UV light. The higher the rate, the higher the antifouling or atmospheric air-cleaning function of the Ti oxide film. Further, the hydrophilic property derived from the visible light-responsive photocatalyst is evaluated by the contact angle between the Ti oxide film and water after the Ti oxide film is irradiated with visible light containing no UV light. The closer the contact angle to 0° (zero degree), the higher the visible light-responsive photocatalytic property of the Ti oxide film.

The glass substrate to be used in the present invention is not particularly limited, but it is preferred to use UV screening glass, since the visible light-responsive photocatalytic film of the present invention can be sufficiently used even at a place where UV light can not be transmitted. The thickness of the glass substrate is preferably from 1.0 to 20 mm from such a viewpoint that both the strength and visibility can be satisfied. Further, the glass substrate may be colorless or colored. The visible light transmittance of the glass substrate is preferably at least 70% from the viewpoint of the visibility. In a case where an alkali metal is contained in the glass, it is preferred to form an undercoating film to prevent diffusion of the alkali component into the Ti oxide film.

Further, by applying a visible light-responsive photocatalytic Ti oxide film of the present invention on UV screening glass having a transmittance at a wavelength of 400 nm being at most 60%, and using the film side as the inside surface of a vehicle such as an automobile or as an inside surface of a building, it is possible to provide a Ti oxide film-coated glass substrate having both the UV screening function, and the antifogging, hydrophilic, gas decomposing, antifouling, fungicidal, antibacterial or atmospheric air-cleaning function. Further, the shape of the glass substrate may be a flat plate form or a variant form.

Further, to meet social needs to prevent human health or cosmetic problems caused by ultraviolet rays or to prevent deterioration of the interior building material by ultraviolet rays, the Ti oxide film of the present invention may be formed on glass having a heat-shielding film or a film to lower the ultraviolet transmittance such as a resin film formed on a glass substrate, or on a Low-E glass having a heat-shielding film applied to improve the comfort, or on laminated glass having a resin inserted between glass sheets to increase the security. Further, by forming a laminate layer of Si oxide on the Ti oxide film of the present invention, it is possible to satisfy both the high transmittance function and the antifouling property. Thus, it becomes possible to maintain the high light transmittance function continuously and free from maintenance, and such a film-coated glass substrate may be applied also to e.g. a cover glass for a solar cell.

Further, also as glass for a vehicle such as an automobile, UV screening glass has been used in many cases to prevent human health or cosmetic problems, to prevent deterioration of the interior material in a vehicle or to improve the comfort. Further, in order to increase the safety, wind-shielding glass has a laminated structure having a resin interposed between glass sheets. Such glass has a low ultraviolet ray transmittance. Therefore, even if a conventional photocatalytic film responsive only to UV light is formed on the interior side of a vehicle, the photocatalytic property can not adequately be obtained. However, the Ti oxide film of the present invention has a visible light-responsive photocatalytic property, and by applying the Ti oxide film on the interior side of the vehicle, it is possible to suitably employ it for a vehicle as glass having an antifogging property and hydrophilicity.

### EXAMPLES

Now, the present invention will be described in further detail with reference to Examples (Examples 1 to 20, 38 to 44 and 46 to 48) and Comparative Examples (Examples 21 to 37, 45 and 49 to 51), but it should be understood that the present invention is by no means thereby restricted. Further, in the following description, mixing ratios of argon gas and nitrogen gas, and mixing ratios of argon gas and oxygen gas, are volume ratios.

### FORMATION OF TiOₓ TARGET

### FORMING EXAMPLE 1

High purity TiO₂ powder (grade: 3N, manufactured by Kojundo Chemical Laboratory Co., Ltd.) was filled in a hot pressing mold made of carbon and subjected to hot pressing in an argon atmosphere at 1,200°C for 1 hour. The hot pressing pressure at that time was 50 kg/cm². The obtained sintered product was mechanically processed into a size of 200 mm × 70 mm having a thickness of 5 mm to obtain a TiOₓ target. The target was used as bonded to a backing plate made of copper, by a metal bond.

### FORMING EXAMPLE 2

Commercially available TiO₂ power (average particle diameter: at most 10 µm) was subjected to wet-mixing with a PVA binder and water as media in a ball mill for 3 hours. The obtained slurry was granulated by means of a spray dryer to obtain a ceramic powder having a particle size of from 20 to 100 µm. Using a copper planar of 220 mm × 90 mm as a target metal holder, its outer surface was surface-roughened by sand blasting by means of Al₂O₃ abrasion grains.

Then, an alloy powder of Ni-Al (weight ratio of 8:2) was subjected to plasma spraying (using a Metco spraying machine) under reduction condition to apply an undercoating layer having a thickness of 50 µm. In this plasma spraying under reduction condition, Ar+H₂ gas was used as the plasma gas at a flow rate of 42.5 L/min, and a power of 35 kV was applied at 700 A, whereby the alloy powder of Ni-Al was instantaneously heated by the Ar+H₂ gas plasma of from 10,000 to 20,000°C and transported together with the gas onto the target metal holder and deposited thereon. Then, using a Ti metal powder, plasma spraying was carried out in the same manner as described above to form an undercoating layer having a thickness of 50 µm. Further, using the above-mentioned ceramic powder, plasma spraying under reduction condition was carried out in the same manner to form a ceramic layer having a final thickness of 5 mm, to form a TiOₓ target.

### MEASUREMENT OF TiOₓ PURITY OF TiOₓ TARGET

Analyses of the impurity concentrations of the TiOₓ targets obtained in Forming Examples 1 and 2 were carried out. A part of each TiOₓ target was pulverized in an agate mortar, and the obtained powder was dissolved by using a 6 mol% hydrochloric acid aqueous solution, whereupon the analysis was carried out by means of ICP (inductively-coupled plasma emission spectrometer). The TiOₓ purity of the TiOₓ target in Forming Example 1 was 99.97 mass%, and the TiOₓ purity of the TiOₓ target in Forming Example 2 was 97.20 mass%. Hereinafter, in Examples (Example 1 to 53), the TiOₓ target in Forming Example 1 will be referred to as the high purity TiOₓ target, and the TiOₓ target in Forming Example 2 will be referred to as the low purity TiOₓ target.

### FORMATION AND EVALUATION OF Ti OXIDE FILM-COATED GLASS SUBSTRATES

### EXAMPLE 1

In a vacuum chamber, the high purity TiOₓ (x=1.984) target (target area: 200 mm × 70 mm) and a glass substrate (Corning #1737, 1.1 mm in thickness, visible light transmittance: 91% (according to JIS R3106 (1998), the same applies hereinafter)) were set, and the chamber was evacuated until the residual gas pressure became not higher than 1×10⁻³ Pa. Then, argon gas was introduced to 3.9 Pa, followed by DC sputtering (discharge power=750 W) to obtain a Ti oxide film-coated glass substrate. The thickness of the Ti oxide film at that time was 50 nm. The film thickness was measured by a contact type film thickness measuring apparatus (Dektak, manufactured by Veeco), and the same applies in the following Examples. During the deposition, no heating of the substrate was carried out. Then, it was fired at 650°C for 10 minutes in the atmospheric air to obtain a Ti oxide film-coated glass. Here, it is considered that under such a firing condition, the surface of the Ti oxide film is TiO₂, and the interior is in the state of TiOₓ.

Further, the composition of the Ti oxide film was substantially the same as the target. Further, the compositions of Ti oxide films in other Examples were substantially the same as the targets, like in Example 1, in a case where no nitrogen was contained in the sputtering gas. On the other hand, in other Examples wherein nitrogen was contained in the sputtering gas, nitrogen was contained in an amount of from 1.5 to 2.0 mass% in the Ti oxide film, and the composition of the Ti oxide film other than nitrogen was substantially the same as the target. Further, the visible light transmittance of the formed Ti oxide film-coated glass substrate was at least 70%.

The conditions for forming the formed Ti oxide film-coated glass substrate are shown in Tables 1 and 2. Further, the hydrophilicity, antifogging property, crystal structure, gas decomposing property and light-responsive current ratio of the formed Ti oxide film-coated glass substrate were evaluated, and the results are shown in Table 3.

Here, the glass substrate of Corning #1737 is alkali-free glass, and soda lime glass is alkali glass having an alkali contained in glass.

The evaluation methods of the obtained Ti oxide film-coated glass are as follows.

### (1) Hydrophilicity

Onto the obtained Ti oxide film, engine oil (tradename: Castle Motor Oil, manufactured by Toyota Motor Corporation) was applied as a contamination source in an amount of 0.22 cm³ on the photocatalytic film and then left to stand for 1 hour. Then, it was washed with water and then dried so that the contact angle became 50 ±10° to obtain a test sample.

This test sample was irradiated with light of a fluorescent lamp (NATIONAL PA-LOOK 18W) (light having light of less than 400 nm cutoff by ultraviolet ray screening glass (tradename: UVFL, manufactured by Asahi Glass Company, Limited) with a distance of 3 cm, whereby the contact angle was measured as time passed.

For the measurement of the contact angle, a contact angle meter (CA-X150 model, manufactured by Kyowa Interface Science Co., Ltd.) was used, and the measurement was made with respect to a droplet of pure water. Further, the intensity of ultraviolet rays at the surface of the test sample was measured by an UV ray intensity meter (UVR-1, manufactured by TOPCON CORPORATION) and confirmed to be less than the detectable limit. Further, the intensity of visible light applied to the test sample was measured by an illumination meter (IM-2D, manufactured by TOPCON CORPORATION) and was found to be 14,000 lux. The temperature for the measurement was 25±3°C, and the relative humidity was 50±10%.

The symbols for the evaluation results in the Tables have the following meanings:
○: The contact angle decreased at least 1.5° in 24 hours.
Δ: The contact angle decreased from 0 to less than 1.5° in 24 hours.
×: The contact angle did not decrease or increased.

### (2) Antifogging property

The obtained Ti oxide film was irradiated with the same visible light as in (1) for 30 days, and the Ti oxide film after the irradiation was held above water surface in a constant temperature tank containing water of 37°C, whereby the time until the visibility decreased, was measured, and the antifogging property was evaluated.

The symbols for the evaluation results in the Tables have the following meanings:
○: The visibility was maintained for at least 40 seconds.
Δ: The visibility was maintained for at least 20 seconds and less than 40 seconds.
×: The visibility was maintained for less than 20 seconds.

### (3) Crystal structure

The obtained Ti oxide film was evaluated by XRD analysis (tradename: RU-200BH, manufactured by Rigaku Corporation). One showing no peak of (101) or (004) indicating an anatase type crystal structure was evaluated to be non-crystalline, and one showing a peak of (101) or (004) indicating an anatase type crystal structure, was evaluated to be anatase crystal.

### (4) Gas decomposing property

The obtained Ti oxide film-coated glass substrate was sealed in a cell so that the acetaldehyde concentration became 50 ppm. Then, it was irradiated with light of a xenon lamp (light having a luminance of 100 mW/cm² within a wavelength range of from 300 to 1,300 nm (light having light of less than 400 nm cutoff by ultraviolet ray screening glass (tradename: UVFL, manufactured by Asahi Glass Company, Limited)), and the relation between the irradiation time from the initiation of the black light irradiation and the acetaldehyde concentration measured by gas chromatography, was measured.

The symbols for evaluation results in the Tables have the following meanings:
○: The concentration of acetaldehyde after 24 hours was less than 10 ppm.
Δ: The concentration of acetaldehyde after 24 hours was from 10 to 30 ppm.
×: The concentration of acetaldehyde after 24 hours exceeded 30 ppm.

### (5) Light-responsive current ratio

Using an ultrasonic electric soldering iron and using Cerasolzer (registered trademark) as a solder material, two electrodes of 20 mm in length × 2 mm in width were soldered with a space of 2 mm on the surface of the obtained Ti oxide film. Then, the Ti oxide film-coated glass substrate was set in a vacuum chamber having a quartz window, and the two electrodes on the Ti oxide film were held down by separate probes for measuring electric current. Further, in a case where a Si oxide film was formed on the Ti oxide film, the electrodes were made to be in contact with the Ti oxide film by rupturing the Si oxide film by Cerasolzer.

By a rotary pump, the interior of the vacuum chamber was evacuated to a pressure of 1 Pa, and in a state where no light was applied to the sample (in a state where the luminance was less than 0.1 mW/cm²), a voltage of 100 V was applied across the attached electrodes, whereby the electric current value (the dark current value) was measured. On the other hand, on the quartz window of the vacuum chamber, UV-IR screening glass (tradename: UVFL, manufactured by Asahi Glass Company, Limited) and a resin for cutting off light of less than 400 nm were set, and from that window, light of a xenon lamp (a wavelength range of from 300 to 1,300 nm, 100 mW/cm²) was applied to irradiate the Ti oxide film located in a distance of 20 cm from the quartz window, and a voltage of 100 V was applied across the attached electrodes, whereby the electric current value (the visible light-responsive current value) was measured. The ratio of the visible light-responsive current value/the dark current was calculated as the light-responsive current ratio.

### EXAMPLE 2

A Ti oxide film-coated glass substrate was obtained in the same manner as in Example 1 except that the thickness of the Ti oxide film in Example 1 was changed to 100 nm, and evaluated in the same manner as in Example 1. The conditions for forming the film-coated glass substrate are shown in Tables 1 and 2, and the evaluation results are shown in Table 3.

### EXAMPLE 3

A Ti oxide film-coated glass substrate was obtained in the same manner as in Example 1 except that the thickness of the Ti oxide film in Example 1 was changed to 200 nm, and evaluated in the same manner as in Example 1. The conditions for forming the film-coated glass substrate are shown in Tables 1 and 2, and the evaluation results are shown in Table 3.

### EXAMPLE 4

In a vacuum chamber, a high purity TiOₓ (x=1.984) target (200 mm × 70 mm) and a glass substrate (Corning #1737, 1.1 mm in thickness, visible light transmittance: 91%) were set, and the chamber was evacuated until the residual gas pressure became not higher than 1×10⁻³ Pa. Then, argon gas and nitrogen gas were introduced in a ratio of 90:10 until the pressure became 3.9 Pa, followed by DC sputtering (discharge power=750 W) to obtain a Ti oxide film-coated glass substrate. The thickness of the Ti oxide film at that time was 15 nm. No heating of the substrate was carried out during the deposition. Then, the substrate was fired at 650°C for 10 minutes in the atmospheric air. The obtained Ti oxide film-coated glass substrate was evaluated in the same manner as in Example 1. The conditions for forming the film-coated glass substrate are shown in Tables 1 and 2, and the evaluation results are shown in Table 3. Further, absorption at a wavelength of 400 nm of the obtained Ti oxide film was 0.5%.

### EXAMPLE 5

A Ti oxide film-coated glass substrate was obtained in the same manner as in Example 4 except that the thickness of the Ti oxide film in Example 4 was changed to 30 nm, and evaluated in the same manner as in Example 1. The conditions for forming the film-coated glass substrate are shown in Tables 1 and 2, and the evaluation results are shown in Table 3.

### EXAMPLE 6

A Ti oxide film-coated glass substrate was obtained in the same manner as in Example 4 except that the thickness of the Ti oxide film in Example 4 was changed to 50 nm, and evaluated in the same manner as in Example 1. The conditions for forming the film-coated glass substrate are shown in Tables 1 and 2, and the evaluation results are shown in Table 3.

The obtained Ti oxide film was subjected to an X-ray photoelectron spectroscopy to analyze the state of Nₗₛ, whereby a peak was observed at the energy position attributable to the Ti-N bond and thus it was found that the Ti-N bond was present. In other Examples wherein nitrogen gas was used as the sputtering gas, it was found that the Ti-N bond was likewise present.

### EXAMPLE 7

A Ti oxide film-coated glass substrate was obtained in the same manner as in Example 4 except that the thickness of the Ti oxide film in Example 4 was changed to 100 nm, and evaluated in the same manner as in Example 1. The conditions for forming the film-coated glass substrate are shown in Tables 1 and 2, and the evaluation results are shown in Table 3.

### EXAMPLE 8

A Ti oxide film-coated glass substrate was obtained in the same manner as in Example 4 except that the thickness of the Ti oxide film in Example 4 was changed to 200 nm, and evaluated in the same manner as in Example 1. The conditions for forming the film-coated glass substrate are shown in Tables 1 and 2, and the evaluation results are shown in Table 3.

### EXAMPLE 9

In a vacuum chamber, a high purity TiOₓ (x=1.984) target (200 mm × 70 mm) and a glass substrate (Corning #1737, 1.1 mm in thickness, visible light transmittance: 91%) were set, and the chamber was evacuated until the residual gas pressure became not higher than 1×10⁻³ Pa. Then, argon gas and nitrogen gas were introduced in a ratio of 50:50 until the pressure became 3.9 Pa, followed by DC sputtering (discharge power=750 W) to obtain a Ti oxide film-coated glass substrate. The thickness of the Ti oxide film at that time was 50 nm. No heating of the substrate was carried out during the deposition. Then, the substrate was fired at 650°C for 10 minutes in the atmospheric air.

The obtained Ti oxide film-coated glass substrate was evaluated in the same manner as in Example 1. The conditions for forming the film-coated glass substrate are shown in Tables 1 and 2, and the evaluation results are shown in Table 3.

### EXAMPLE 10

A Ti oxide film-coated glass substrate was obtained in the same manner as in Example 9 except that during the deposition of the Ti oxide film in Example 9, the argon gas and the nitrogen gas were introduced in a ratio of 10:90, and evaluated in the same manner as in Example 1. The conditions for forming the film-coated glass substrate are shown in Tables 1 and 2, and the evaluation results are shown in Table 3.

### EXAMPLE 11

A Ti oxide film-coated glass substrate was obtained in the same manner as in Example 9 except that during the deposition of the Ti oxide film in Example 9, the argon gas and the nitrogen gas were introduced in a ratio of 20:80, and evaluated in the same manner as in Example 1. The conditions for forming the film-coated glass substrate are shown in Tables 1 and 2, and the evaluation results are shown in Table 3.

### EXAMPLE 12 (Example wherein an undercoating film was formed)

In a vacuum chamber, a high purity TiOₓ (x=1.984) target (200 mm × 70 mm), a boron-doped silicon target (200 mm × 70 mm) and a glass substrate (UV-IR screening soda lime glass, 3.5 mm in thickness, transmittance at 400 nm: 60%) were set, and the chamber was evacuated until the back pressure became not higher than 1×10⁻³ Pa. Then, oxygen gas was introduced until the pressure became 3.9 Pa, followed by DC sputtering (discharge power=1,000 W) to obtain a Si oxide film-coated glass substrate. The thickness of the Si oxide film at that time was 100 nm. No heating of the substrate was carried out during the deposition. Then, argon gas was introduced until the pressure became 3.9 Pa, followed by DC sputtering (discharge power=750 W) to obtain a Ti oxide film-coated glass substrate. The thickness of the Ti oxide film at that time was 50 nm. No heating of the substrate was carried out during the deposition. Then, the substrate was fired at 650°C for 10 minutes in the atmospheric air.

The obtained Ti oxide film-coated glass substrate was evaluated in the same manner as in Example 1. The conditions for forming the film-coated glass substrate are shown in Tables 1 and 2, and the evaluation results are shown in Table 3.

### EXAMPLE 13

A Ti oxide film-coated glass substrate was obtained in the same manner as in Example 12 except that during the deposition of the Ti oxide film in Example 12, the gas introduced was changed to argon:nitrogen=90:10, and evaluated in the same manner as in Example 1. The conditions for forming the film-coated glass substrate are shown in Tables 1 and 2, and the evaluation results are shown in Table 3.

### EXAMPLE 14 (Example wherein an overcoating was formed)

In a vacuum chamber, a high purity TiOₓ (x=1.984) target (200 mm × 70 mm), a boron-doped silicon target (200 mm × 70 mm) and a glass substrate (Corning #1737, 1.1 mm in thickness, visible light transmittance: 91%) were set, and the chamber was evacuated until the residual gas pressure became not higher than 1×10⁻³ Pa. Then, argon gas was introduced until the pressure became 3.9 Pa, followed by DC sputtering (discharge power=750 W) to obtain a Ti oxide film-coated glass substrate. The thickness of the Ti oxide film at that time was 50 nm. No heating of the substrate was carried out during the deposition. Then, the oxygen gas was introduced until the pressure became 3.3 Pa, followed by DC sputtering (discharge power=1,000 W) to obtain a Si oxide film-coated glass substrate. The thickness of the Si oxide film at that time was 10 nm. No heating of the substrate was carried out during the deposition. Then, the substrate was fired at 650°C for 10 minutes in the atmospheric air.

The obtained Ti oxide film-coated glass substrate was evaluated in the same manner as in Example 1. The conditions for forming the film-coated glass substrate are shown in Tables 1 and 2, and the evaluation results are shown in Table 3.

### EXAMPLE 15

A Ti oxide/Si oxide laminated film-coated glass substrate was obtained in the same manner as in Example 14 except that the thickness of the Si oxide film in Example 14 was changed to 50 nm, and evaluated in the same manner as in Example 1. The conditions for forming the film-coated glass substrate are shown in Tables 1 and 2, and the evaluation results are shown in Table 3.

### EXAMPLE 16

A Ti oxide/silicon oxide laminated film-coated glass substrate was obtained in the same manner as in Example 14 except that the thickness of the Si oxide film in Example 14 was changed to 100 nm, and evaluated in the same manner as in Example 1. The conditions for forming the film-coated glass substrate are shown in Tables 1 and 2, and the evaluation results are shown in Table 3.

### EXAMPLE 17

A Ti oxide/Si oxide laminated film-coated glass substrate was obtained in the same manner as in Example 14 except that the pressure during the deposition of the Si oxide film in Example 14 was changed to 2.0 Pa, and evaluated in the same manner as in Example 1. The conditions for forming the film-coated glass substrate are shown in Tables 1 and 2, and the evaluation results are shown in Table 3.

### EXAMPLE 18

A Ti oxide film-coated glass substrate was obtained in the same manner as in Example 1 except that the time for firing the Ti oxide film in Example 1 was changed to 3 minutes, and evaluated in the same manner as in Example 1. The conditions for forming the film-coated glass substrate are shown in Tables 1 and 2, and the evaluation results are shown in Table 3.

### EXAMPLE 19

A Ti oxide film-coated glass substrate was obtained in the same manner as in Example 1 except that the time for firing the Ti oxide film in Example 1 was changed to 25 minutes, and evaluated in the same manner as in Example 1. The conditions for forming the film-coated glass substrate are shown in Tables 1 and 2, and the evaluation results are shown in Table 3.

### EXAMPLE 20

A Ti oxide film-coated glass substrate was obtained in the same manner as in Example 1 except that the pressure during the deposition of the Ti oxide film in Example 1 was changed to 2.0 Pa, and evaluated in the same manner as in Example 1. The conditions for forming the film-coated glass substrate are shown in Tables 1 and 2, and the evaluation results are shown in Table 3.

### EXAMPLE 21 (Comparative Example)

In a vacuum chamber, a low purity TiOₓ (x=1.984) target (200 mm × 70 mm) and a glass substrate (Corning #1737, 1.1 mm in thickness, visible light transmittance: 91%) were set, and the chamber was evacuated until the residual gas pressure became not higher than 1×10⁻³ Pa. Then, argon gas was introduced until the pressure became 3.9 Pa, followed by DC sputtering (discharge power=750 W) to obtain a Ti oxide film-coated glass substrate. The thickness of the Ti oxide film at that time was 50 nm. No heating of the substrate was carried out during the deposition. Then, the substrate was fired at 650°C for 10 minutes in the atmospheric air.

The obtained Ti oxide film-coated glass substrate was evaluated in the same manner as in Example 1. The conditions for forming the film-coated glass substrate are shown in Tables 4 and 5, and the evaluation results are shown in Table 6.

### EXAMPLE 22 (Comparative Example)

A Ti oxide film-coated glass substrate was obtained in the same manner as in Example 21 except that the thickness of the Ti oxide film in Example 21 was changed to 100 nm, and evaluated in the same manner as in Example 1. The conditions for forming the film-coated glass substrate are shown in Tables 4 and 5, and the evaluation results are shown in Table 6.

### EXAMPLE 23 (Comparative Example)

In a vacuum chamber, a low purity TiOₓ (x=1.984) target (200 mm × 70 mm) and a glass substrate (Corning #1737, 1.1 mm in thickness, visible light transmittance: 91%) were set, and the chamber was evacuated until the residual gas pressure became not higher than 1×10⁻³ Pa. Then, argon gas and nitrogen gas were introduced in a ratio of 90:10 until the pressure became 3.9 Pa, followed by DC sputtering (discharge power=750 W) to obtain a Ti oxide film-coated glass substrate. The thickness of the Ti oxide film at that time was 15 nm. No heating of the substrate was carried out during the deposition. Then, the substrate was fired at 650°C for 10 minutes in the atmospheric air.

The obtained Ti oxide film-coated glass substrate was evaluated in the same manner as in Example 1. The conditions for forming the film-coated glass substrate are shown in Tables 4 and 5, and the evaluation results are shown in Table 6.

### EXAMPLE 24 (Comparative Example)

A Ti oxide film-coated glass substrate was obtained in the same manner as in Example 23 except that the thickness of the Ti oxide film in Example 23 was changed to 50 nm, and evaluated in the same manner as in Example 1. The conditions for forming the film-coated glass substrate are shown in Tables 4 and 5, and the evaluation results are shown in Table 6.

### EXAMPLE 25 (Comparative Example)

A Ti oxide film-coated glass substrate was obtained in the same manner as in Example 23 except that the thickness of the Ti oxide film in Example 23 was changed to 100 nm, and evaluated in the same manner as in Example 1. The conditions for forming the film-coated glass substrate are shown in Tables 4 and 5, and the evaluation results are shown in Table 6.

### EXAMPLE 26 (Comparative Example) (Example wherein no firing is carried out after the deposition)

In a vacuum chamber, a high purity TiOₓ (x=1.984) target (200 mm × 70 mm) and a glass substrate (Corning #1737, 1.1 mm in thickness, visible light transmittance: 91%) were set, and the chamber was evacuated until the residual gas pressure became not higher than 1×10⁻³ Pa. Then, argon gas and nitrogen gas were introduced in a ratio of 90:10 until the pressure became 3.9 Pa, followed by DC sputtering (discharge power=750 W) to obtain a Ti oxide film-coated glass substrate. The thickness of the Ti oxide film at that time was 50 nm. No heating of the substrate was carried out during the deposition.

The obtained Ti oxide film-coated glass substrate was evaluated in the same manner as in Example 1. The conditions for forming the film-coated glass substrate are shown in Tables 4 and 5, and the evaluation results are shown in Table 6.

### EXAMPLE 27 (Comparative Example)

A Ti oxide film-coated glass substrate was obtained in the same manner as in Example 26 except that the thickness of the Ti oxide film in Example 26 was changed to 100 nm, and evaluated in the same manner as in Example 1. The conditions for forming the film-coated glass substrate are shown in Tables 4 and 5, and the evaluation results are shown in Table 6.

### EXAMPLE 28 (Comparative Example)

A Ti oxide film-coated glass substrate was obtained in the same manner as in Example 26 except that the thickness of the Ti oxide film in Example 26 was changed to 200 nm, and evaluated in the same manner as in Example 1. The conditions for forming the film-coated glass substrate are shown in Tables 4 and 5, and the evaluation results are shown in Table 6.

### EXAMPLE 29 (Comparative Example)

A Ti oxide film-coated glass substrate was obtained in the same manner as in Example 26 except that the gas introduced in Example 26 was changed to argon gas and nitrogen gas=90:10, and evaluated in the same manner as in Example 1. The conditions for forming the film-coated glass substrate are shown in Tables 4 and 5, and the evaluation results are shown in Table 6.

### EXAMPLE 30 (Comparative Example)

A Ti oxide film-coated glass substrate was obtained in the same manner as in Example 29 except that the thickness of the Ti oxide film in Example 29 was changed to 100 nm, and evaluated in the same manner as in Example 1. The conditions for forming the film-coated glass substrate are shown in Tables 4 and 5, and the evaluation results are shown in Table 6.

### EXAMPLE 31 (Comparative Example)

A Ti oxide film-coated glass substrate was obtained in the same manner as in Example 29 except that the thickness of the Ti oxide film in Example 29 was changed to 200 nm, and evaluated in the same manner as in Example 1. The conditions for forming the film-coated glass substrate are shown in Tables 4 and 5, and the evaluation results are shown in Table 6.

### EXAMPLE 32 (Comparative Example) (Example wherein alkali glass was used)

In a vacuum chamber, a high purity TiOₓ (x=1.984) target (200 mm × 70 mm) and a glass substrate (UV-IR screening soda lime glass, 3.5 mm in thickness, transmittance at 400 nm: 60%) were set, and the chamber was evacuated until the residual gas pressure became not higher than 1×10⁻³ Pa. Then, argon gas was introduced until the pressure became 3.9 Pa, followed by DC sputtering (discharge power=750 W) to obtain a Ti oxide film-coated glass substrate. The thickness of the Ti oxide film at that time was 50 nm. No heating of the substrate was carried out during the deposition. Then, the substrate was fired at 650°C for in 10 minutes in the atmospheric air.

The obtained Ti oxide film-coated glass substrate was evaluated in the same manner as in Example 1. The conditions for forming the film-coated glass substrate are shown in Tables 4 and 5, and the evaluation results are shown in Table 6.

### EXAMPLE 33 (Comparative Example)

A Ti oxide film-coated glass substrate was obtained in the same manner as in Example 32 except that the thickness of the Ti oxide film in Example 32 was changed to 100 nm, and evaluated in the same manner as in Example 1. The conditions for forming the film-coated glass substrate are shown in Tables 4 and 5, and the evaluation results are shown in Table 6.

### EXAMPLE 34 (Comparative Example)

A Ti oxide film-coated glass substrate was obtained in the same manner as in Example 32 except that the thickness of the Ti oxide film in Example 32 was changed to 200 nm, and evaluated in the same manner as in Example 1. The conditions for forming the film-coated glass substrate are shown in Tables 4 and 5, and the evaluation results are shown in Table 6.

### EXAMPLE 35 (Comparative Example) (Example wherein an overcoating layer was formed)

In a vacuum chamber, a high purity TiOₓ (x=1.984) target (200 mm × 70 mm), a boron-doped silicon target (200 mm × 70 mm) and a glass substrate (Corning #1737 glass, 1.1 mm in thickness, visible light transmittance: 91%) were set, and the chamber was evacuated until the residual gas pressure became not higher than 1×10⁻³ Pa. Then, argon gas was introduced until the pressure became 3.9 Pa, followed by DC sputtering (discharge power=750 W) to obtain a Ti oxide film-coated glass substrate. The thickness of the Ti oxide film at that time was 200 nm. No heating of the substrate was carried out during the deposition. Then, oxygen gas was introduced until the pressure became 0.5 Pa, followed by DC sputtering (discharge power=1,000 W) to obtain a Si oxide film-coated glass substrate. The thickness of the Si oxide film at that time was 10 nm. No heating of the substrate was carried out during the deposition. Then, the substrate was fired at 650°C for 10 minutes in the atmospheric air.

The obtained Ti oxide film-coated glass substrate was evaluated in the same manner as in Example 1. The conditions for forming the film-coated glass substrate are shown in Tables 4 and 5, and the evaluation results are shown in Table 6.

### EXAMPLE 36 (Comparative Example)

A Ti oxide film-coated glass substrate was obtained in the same manner as in Example 1 except that the atmosphere for firing the Ti oxide film in Example 1 was changed to a nitrogen atmosphere, and the time for firing was changed to 10 minutes, and evaluated in the same manner as in Example 1. The conditions for forming the film-coated glass substrate are shown in Tables 4 and 5, and the evaluation results are shown in Table 6. It is considered that by the firing in the above nitrogen atmosphere, the Ti oxide film was not oxidized.

### EXAMPLE 37 (Comparative Example)

A Ti oxide film-coated glass substrate was obtained in the same manner as in Example 1 except that the time for firing the Ti oxide film in Example 1 was changed to 40 minutes, and evaluated in the same manner as in Example 1. The conditions for forming the film-coated glass substrate are shown in Tables 4 and 5, and the evaluation results are shown in Table 6. It is considered that in the above firing time, the Ti oxide film was in a state where it was oxidized to the interior.

### EXAMPLE 38

A Ti oxide film-coated glass substrate was obtained in the same manner as in Example 1 except that the residual gas pressure in Example 1 was changed to 6.0×10⁻⁴ Pa, and evaluated in the same manner as in Example 1. The conditions for forming the film-coated glass substrate are shown in Tables 7 and 8, and the evaluation results are shown in Table 9.

### EXAMPLE 39

A Ti oxide film-coated glass substrate was obtained in the same manner as in Example 1 except that the residual gas pressure in Example 1 was changed to 2.7×10⁻⁴ Pa, and evaluated in the same manner as in Example 1. The conditions for forming the film-coated glass substrate are shown in Tables 7 and 8, and the evaluation results are shown in Table 9.

### EXAMPLE 40

A Ti oxide film-coated glass substrate was obtained in the same manner as in Example 38 except that the gas introduced for the deposition of the Ti oxide film in Example 38 was changed to argon gas:nitrogen gas=90:10, and evaluated in the same manner as in Example 1. The conditions for forming the film-coated glass substrate are shown in Tables 7 and 8, and the evaluation results are shown in Table 9.

### EXAMPLE 41

A Ti oxide film-coated glass substrate was obtained in the same manner as in Example 39 except that the gas introduced during the deposition of the Ti oxide film in Example 39 was changed to argon gas:nitrogen gas=90:10, and evaluated in the same manner as in Example 1. The conditions for forming the film-coated glass substrate are shown in Tables 7 and 8, and the evaluation results are shown in Table 9.

### EXAMPLE 42

A Ti oxide film-coated glass substrate was obtained in the same manner as in Example 1 except that the discharge power in Example 1 was changed to 0.5 kW, and evaluated in the same manner as in Example 1. The conditions for forming the film-coated glass substrate are shown in Tables 7 and 8, and the evaluation results are shown in Table 9.

### EXAMPLE 43

A Ti oxide film-coated glass substrate was obtained in the same manner as in Example 1 except that the discharge power for the Ti oxide film in Example 42 was changed to 1 kW, and evaluated in the same manner as in Example 42. The conditions for forming the film-coated glass substrate are shown in Tables 7 and 8, and the evaluation results are shown in Table 9.

### EXAMPLE 44

A Ti oxide film-coated glass substrate was obtained in the same manner as in Example 42 except that the gas introduced during the deposition of the Ti oxide film in Example 42 was changed to argon gas:nitrogen gas=90:10, and evaluated in the same manner as in Example 1. The conditions for forming the film-coated glass substrate are shown in Tables 7 and 8, and the evaluation results are shown in Table 9.

### EXAMPLE 45 (Comparative Example)

A Ti oxide film-coated glass substrate was obtained in the same manner as in Example 43 except that the gas introduced during the deposition of the Ti oxide film in Example 43 was changed to argon gas:nitrogen gas=90:10, and evaluated in the same manner as in Example 1. The conditions for forming the film-coated glass substrate are shown in Tables 7 and 8, and the evaluation results are shown in Table 9.

### EXAMPLE 46

A Ti oxide film-coated glass substrate was obtained in the same manner as in Example 1 except that the gas introduced during the deposition of the Ti oxide film in Example 1 was changed to argon gas:oxygen gas=99:1, and evaluated in the same manner as in Example 1. The conditions for forming the film-coated glass substrate are shown in Tables 7 and 8, and the evaluation results are shown in Table 9. Further, the absorption at a wavelength of 400 nm of the obtained Ti oxide film was 1.0%.

### EXAMPLE 47

A Ti oxide film-coated glass substrate was obtained in the same manner as in Example 1 except that the gas introduced during the deposition of the Ti oxide film in Example 1 was changed to argon gas:oxygen gas=97:3, and evaluated in the same manner as in Example 1. The conditions for forming the film-coated glass substrate are shown in Tables 7 and 8, and the evaluation results are shown in Table 9.

### EXAMPLE 48

A Ti oxide film-coated glass substrate was obtained in the same manner as in Example 1 except that the gas introduced during the deposition of the Ti oxide film in Example 1 was changed to argon gas:oxygen gas=95:5, and evaluated in the same manner as in Example 1. The conditions for forming the film-coated glass substrate are shown in Tables 7 and 8, and the evaluation results are shown in Table 9.

### EXAMPLE 49 (Comparative Example)

A Ti oxide film-coated glass substrate was obtained in the same manner as in Example 21 except that the gas introduced during the deposition of the Ti oxide film in Example 21 was changed to argon gas:oxygen gas=99:1, and evaluated in the same manner as in Example 1. The conditions for forming the film-coated glass substrate are shown in Tables 7 and 8, and the evaluation results are shown in Table 9.

### EXAMPLE 50 (Comparative Example)

A Ti oxide film-coated glass substrate was obtained in the same manner as in Example 21 except that the gas introduced during the deposition of the Ti oxide film in Example 21 was changed to argon gas:oxygen gas=97:3, and evaluated in the same manner as in Example 1. The conditions for forming the film-coated glass substrate are shown in Tables 7 and 8, and the evaluation results are shown in Table 9.

### EXAMPLE 51 (Comparative Example)

A Ti oxide film-coated glass substrate was obtained in the same manner as in Example 21 except that the gas introduced during the deposition of the Ti oxide film in Example 21 was changed to argon gas:oxygen gas=95:5, and evaluated in the same manner as in Example 1. The conditions for forming the film-coated glass substrate are shown in Tables 7 and 8, and the evaluation results are shown in Table 9.

### EXAMPLE 52

In a vacuum chamber, a low purity TiOₓ (x=1.984) target (200 mm × 70 mm), a SC target (manufactured by Asahi Glass Ceramics, Co., Ltd., Si:50 atomic%, SiC:50 atomic%), a high purity TiOₓ (x=1.984) target (200 mm × 70 mm), a glass substrate (UV-IR screening soda lime glass, 3.5 mm in thickness, transmittance at 400 nm: 60%) were set, and the chamber was evacuated until the residual gas pressure immediately before the deposition became not higher than 1×10⁻³ Pa. Then, argon gas and oxygen gas were introduced in a ratio of 97:3 until the pressure became 0.47 Pa, followed by DC sputtering (discharge power=750 W) to form a Ti oxide film by using the low purity TiOₓ target. The thickness of the Ti oxide film was 90 nm.

Then, the chamber was evacuated until the residual gas pressure immediately before the deposition became not higher than 1×10⁻³ Pa. Argon gas and oxygen gas were introduced in a ratio of 7:3 until the pressure became 0.5 Pa, followed by DC sputtering (discharge power=750 W) to form a Si oxide film on the Ti oxide film by using the SC target. The thickness of the Si oxide film was 145 nm.

Then, the chamber was evacuated until the residual gas pressure immediately before the deposition became not higher than 1×10⁻³ Pa, and argon gas and nitrogen gas were introduced in a ratio of 9:1 until the pressure became 3.9 Pa, followed by DC sputtering (discharge power=750 W) to form a Ti oxide film on the Si oxide film by using the high purity TiOₓ target. The thickness of the Ti oxide film was 90 nm.

Then, the chamber was evacuated until the residual gas pressure immediately before the deposition became not higher than 1×10⁻³ Pa. Argon gas and oxygen gas were introduced in a ratio of 7:3 until the pressure became 2.0 Pa, followed by DC sputtering (discharge power=750 W) to form a Si oxide film on the Ti oxide film by using the SC target. The thickness of the Si oxide film was 30 nm.

The obtained laminate of glass/Ti oxide film/Si oxide film/Ti oxide film/Si oxide film had a visible light transmittance of 73% and a sunlight transmittance of 37%, according to JIS R3106 (1998) and thus was found to have sufficient IR screening function. The hydrophilicity, antifogging property, crystal structure and gas decomposing property of the formed laminate were evaluated, and the results are shown in Table 9.

### EXAMPLE 53

In a vacuum chamber, a low purity TiOₓ (x=1.984) target (200 mm × 70 mm), a SC target (manufactured by Asahi Glass Ceramics, Co., Ltd., Si:50 atomic%, SiC:50 atomic%), a high purity TiOₓ (x=1.984) target (200 mm × 70 mm), a glass substrate (UV-IR screening soda lime glass, 3.5 mm in thickness, transmittance at 400 nm: 60%) were set, and the chamber was evacuated until the residual gas pressure immediately before the deposition became not higher than 1×10⁻³ Pa. Then, argon gas and oxygen gas were introduced in a ratio of 97:3 until the pressure became 0.47 Pa, followed by DC sputtering (discharge power=750 W) to form a Ti oxide film by using the low purity TiOₓ target. The thickness of the Ti oxide film was 11 nm.

Then, the chamber was evacuated until the residual gas pressure immediately before the deposition became not higher than 1×10⁻³ Pa. Argon gas and oxygen gas were introduced in a ratio of 7:3 until the pressure became 0.5 Pa, followed by DC sputtering (discharge power=750 W) to form a Si oxide film on the Ti oxide film by using the SC target. The thickness of the Si oxide film was 26 nm.

Then, the chamber was evacuated until the residual gas pressure immediately before the deposition became not higher than 1×10⁻³ Pa, and argon gas and nitrogen gas were introduced in a ratio of 9:1 until the pressure became 3.9 Pa, followed by DC sputtering (discharge power=750 W) to form a Ti oxide film on the Si oxide film by using the high purity TiOₓ target. The thickness of the Ti oxide film was 110 nm.

Then, the chamber was evacuated until the residual gas pressure immediately before the deposition became not higher than 1×10⁻³ Pa, and argon gas and oxygen gas were introduce in a ratio of 7:3 until the pressure became 2.0 Pa, followed by DC sputtering (discharge power=750 W) to form a Si oxide film on the Ti oxide film by using the SC target. The thickness of the Si oxide film was 100 nm.

The laminate of glass/Ti oxide film/Si oxide film/Ti oxide film/Si oxide film thus obtained had a visible light transmittance of 78% and a visible light reflectance of 4%, according to JIS R3106 (1998) and thus was found to have AR function. The hydrophilicity, antifogging property, crystal structure and gas decomposing property of the formed laminate were evaluated, and the results are shown in Table 9. From Table 9, it is evident that even when the overcoating film is a thick film having a thickness of at least 80 nm, a visible light photocatalytic property can be obtained.

**TABLE 1**

| | Ti oxide film | | | | | | |
|---|---|---|---|---|---|---|---|
| Example No. | Type of glass substrate | Type of target | Pressure of gas (volume ratio) introduced during deposition | Residual gas pressure | Discharge power (kW) | Film thickness (nm) | Condition for firing |
| 1 | #1737 | High purity TiOₓ | Ar only 3.9 Pa | 1E-3Pa | 0.75 | 50 | In atmospheric air 650°C 10 minutes |
| 2 | Same as above | Same as above | Same as above | Same as above | Same as above | 100 | Same as above |
| 3 | Same as above | Same as above | Same as above | Same as above | Same as above | 200 | Same as above |
| 4 | Same as above | Same as above | Ar/N₂=90/10 3.9 Pa | Same as above | Same as above | 15 | Same as above |
| 5 | Same as above | Same as above | Same as above | Same as above | Same as above | 30 | Same as above |
| 6 | Same as above | Same as above | Same as above | Same as above | Same as above | 50 | Same as above |
| 7 | Same as above | Same as above | game as above | Same as above | Same as above | 100 | Same as above |
| 8 | Same as above | Same as above | Same as above | Same as above | Same as above | 200 | Same as above |
| 9 | Same as above | Same as above | Ar/N₂=50/50 3.9 Pa | Same as above | Same as above | 50 | Same as above |
| 10 | Same as above | Same as above | Ar/N₂=10/90 3.9 Pa | Same as above | Same as above | Same as above | Same as above |
| 11 | Same as above | Same as above | Ar/N₂=20/80 3.9 Pa | Same as above | Same as above | Same as above | Same as above |
| 12 | Soda lime glass | Same as above | Ar only 3.9 Pa | Same as above | Same as above | Same as above | Same as above |
| 13 | Same as above | Same as above | Ar/N₂=90/10 3.9 Pa | Same as above | Same as above | Same as above | Same as above |
| 14 | #1737 | Same as above | Ar only 3.9 Pa | Same as above | Same as above | Same as above | Same as above |
| 15 | Same as above | Same as above | Same as above | Same as above | Same as above | Same as above | Same as above |
| 16 | Same as above | Same as above | Same as above | Same as above | Same as above | Same as above | Same as above |
| 17 | Same as above | Same as above | Same as above | Same as above | Same as above | Same as above | Same as above |
| 18 | Same as above | Same as above | Same as above | Same as above | Same as above | Same as above | In atmospheric air 650°C 3 minutes |
| 19 | Same as above | Same as above | Same as above | Same as above | Same as above | Same as above | In atmospheric air 650°C 25 minutes |
| 20 | Same as above | Same as above | Ar only 2.0 Pa | Same as above | Same as above | Same as above | In atmospheric air 650°C 10 minutes |

**TABLE 2**

| | Undercoating film (SiO₂ film) | Overcoating (SiO₂ film) | |
|---|---|---|---|
| Example No. | Film thickness (nm) | Film thickness (nm) | Pressure for deposition (Pa) |
| 1 | Nil | Nil | Nil |
| 2 | Same as above | Same as above | Same as above |
| 3 | Same as above | Same as above | Same as above |
| 4 | Same as above | Same as above | Same as above |
| 5 | Same as above | Same as above | Same as above |
| 6 | Same as above | Same as above | Same as above |
| 7 | Same as above | Same as above | Same as above |
| 8 | Same as above | Same as above | Same as above |
| 9 | Same as above | Same as above | Same as above |
| 10 | Same as above | Same as above | Same as above |
| 11 | Same as above | Same as above | Same as above |
| 12 | Same as above | Same as above | Same as above |
| 13 | Same as above | Same as above | Same as above |
| 14 | Nil | 10 | 3.3 |
| 15 | Same as above | 50 | 3.3 |
| 16 | Same as above | 100 | 3.3 |
| 17 | Same as above | 10 | 2.0 |
| 18 | Same as above | Nil | Nil |
| 19 | Same as above | Same as above | Same as above |
| 20 | Same as above | Same as above | Same as above |

**TABLE 3**

| Example No. | Hydrophilicity | Antifogging property | Crystal structure | Gas decomposing property | Light-responsive current ratio |
|---|---|---|---|---|---|
| 1 | Δ | Δ | Anatase | ○ | 1660 |
| 2 | ○ | Δ | Same as above | ○ | 4270 |
| 3 | ○ | Δ | Same as above | ○ | 73000 |
| 4 | Δ | Δ | Same as above | ○ | 7770 |
| 5 | Δ | Δ | Same as above | ○ | 23300 |
| 6 | ○ | Δ | Same as above | ○ | 38500 |
| 7 | ○ | Δ | Same as above | ○ | 102000 |
| 8 | ○ | Δ | Same as above | ○ | 152000 |
| 9 | ○ | Δ | Same as above | ○ | 1320 |
| 10 | ○ | Δ | Same as above | ○ | 1010 |
| 11 | Δ | Δ | Same as above | Δ | 1010 |
| 12 | ○ | Δ | Same as above | ○ | 5530 |
| 13 | ○ | ○ | Same as above | ○ | 2010 |
| 14 | ○ | ○ | Same as above | Δ | 5500 |
| 15 | Δ | ○ | Same as above | Δ | 10500 |
| 16 | Δ | ○ | Same as above | Δ | 19500 |
| 17 | Δ | ○ | Same as above | Δ | 12300 |
| 18 | ○ | ○ | Same as above | ○ | 2400 |
| 19 | Δ | Δ | Same as above | Δ | 1200 |
| 20 | Δ | Δ | Same as above | Δ | 1340 |

**TABLE 4**

| | Ti oxide film | | | | | | |
|---|---|---|---|---|---|---|---|
| Example No. | Type of glass substrate | Type of target | Pressure of gas (volume ratio) introduced during deposition | Residual gas pressure | Discharge power (kW) | Film thickness (nm) | Condition for firing |
| 21 | #1737 | Low purity TiOₓ | Ar only 3.9 Pa | 1E-3Pa | 0.75 | 50 | In atmospheric air 650°C 10 minutes |
| 22 | Same as above | Same as above | Same as above | Same as above | Same as above | 100 | Same as above |
| 23 | Same as above | Same as above | Ar/N₂=90/10 3.9 Pa | Same as above | Same as above | 15 | Same as above |
| 24 | Same as above | Same as above | Same as above | Same as above | Same as above | 50 | Same as above |
| 25 | Same as above | Same as above | Same as above | Same as above | Same as above | 100 | Same as above |
| 26 | Same as above | High purity TiOₓ | Ar only 3.9 Pa | Same as above | Same as above | 50 | Nil |
| 27 | Same as above | Same as above | Same as above | Same as above | Same as above | 100 | Same as above |
| 28 | Same as above | Same as above | Same as above | Same as above | Same as above | 200 | Same as above |
| 29 | Same as above | Same as above | Ar/N₂=90/10 3.9 Pa | Same as above | Same as above | 50 | Same as above |
| 30 | Same as above | Same as above | Same as above | Same as above | Same as above | 100 | Same as above |

| | | | | | | | |
|---|---|---|---|---|---|---|---|
| 31 | Same as above | Same as above | Same as above | Same as above | Same as above | 200 | Same as above |
| 32 | Soda lime glass | Same as above | Ar only 3.9 Pa | Same as above | Same as above | 50 | In atmospheric air 650°C 10 minutes |
| 33 | Same as above | Same as above | Same as above | Same as above | Same as above | 100 | Same as above |
| 34 | Same as above | Same as above | Same as above | Same as above | Same as above | 200 | Same as above |
| 35 | #1737 | Same as above | Same as above | Same as above | Same as above | 50 | Same as above |
| 36 | Same as above | Same as above | Ar only 3.9 Pa | Same as above | Same as above | Same as above | In nitrogen 650°C 10 minutes |
| 37 | Same as above | Same as above | Same as above | Same as above | Same as above | Same as above | In atmospheric air 650°C 40 minutes |

| | | | | | | | |
|---|---|---|---|---|---|---|---|
| (continued) | | | | | | | |

**TABLE 5**

| | Undercoating film (SiO₂ film) | Overcoating (SiO₂ film) | |
|---|---|---|---|
| Example No. | Film thickness (nm) | Film thickness (nm) | Pressure for deposition (Pa) |
| 21 | Nil | Nil | Nil |
| 22 | Same as above | Same as above | Same as above |
| 23 | Same as above | Same as above | Same as above |
| 24 | Same as above | Same as above | Same as above |
| 25 | Same as above | Same as above | Same as above |
| 26 | Same as above | Same as above | Same as above |
| 27 | Same as above | Same as above | Same as above |
| 28 | Same as above | Same as above | Same as above |
| 29 | Same as above | Same as above | Same as above |
| 30 | Same as above | Same as above | Same as above |
| 31 | Same as above | Same as above | Same as above |
| 32 | Same as above | Same as above | Same as above |
| 33 | Same as above | Same as above | Same as above |
| 34 | Same as above | Same as above | Same as above |
| 35 | Same as above | 10 | 0.5 |
| 36 | Same as above | Nil | Nil |
| 37 | Same as above | Same as above | Same as above |

**Table 6**

| Example No. | Hydrophilicity | Anti-fogging property | Crystal structure | Gas decomposing property | Light-responsive current ratio |
|---|---|---|---|---|---|
| 21 | × | × | Anatase | × | 1.01 |
| 22 | × | × | Same as above | × | 1.02 |
| 23 | × | × | Same as above | × | 1.1 |
| 24 | × | × | Same as above | × | 1.03 |
| 25 | × | × | Same as above | × | 1.04 |
| 26 | × | × | Non-crystalline | × | 72.5 |
| 27 | × | × | Same as above | × | 5.25 |
| 28 | × | × | Same as above | × | 13.2 |
| 29 | × | × | Same as above | × | 6.35 |
| 30 | × | × | Same as above | × | 60.6 |
| 31 | × | × | Same as above | × | 50.4 |
| 32 | × | × | Same as above | × | 24.5 |
| 33 | × | × | Same as above | × | 120 |
| 34 | × | × | Same as above | × | 750 |
| 35 | × | × | Same as above | × | 65 |
| 36 | × | × | Anatase | × | 910 |
| 37 | × | × | Same as above | × | 130 |

**TABLE 7**

| | Ti oxide film | | | | | | |
|---|---|---|---|---|---|---|---|
| Example No. | Type of glass substrate | Type of target | Pressure of gas (volume ratio) introduced during deposition | Residual gas pressure | Discharge power (kW) | Film thickness (nm) | Condition for firing |
| 38 | #1737 | High purity TiOₓ | Ar only 3.9 Pa | 6.0E-4Pa | 0.75 | 50 | In atmospheric air 650°C 10 minutes |
| 39 | Same as above | Same as above | Same as above | 2.7E-4Pa | Same as above | Same as above | Same as above |
| 40 | Same as above | Same as above | Ar/N₂=90/10 3.9 Pa | 6.0E-4Pa | Same as above | Same as above | Same as above |
| 41 | Same as above | Same as above | Same as above | 2.7E-4Pa | Same as above | Same as above | Same as above |
| 42 | Same as above | Same as above | Ar only 3.9 Pa | 1E-3Pa | 0.5 | Same as above | Same as above |
| 43 | Same as above | Same as above | Same as above | Same as above | 1.0 | Same as above | Same as above |
| 44 | Same as above | Same as above | Ar/N₂=90/10 3.9 Pa | Same as above | 0.5 | Same as above | Same as above |
| 45 | Same as above | Same as above | Same as above | Same as above | 1.0 | Same as above | Same as above |
| 46 | Same as above | Same as above | Ar/O₂=99/1 3.9 Pa | Same as above | 0.75 | Same as above | Same as above |

| | | | | | | | |
|---|---|---|---|---|---|---|---|
| 47 | Same as above | Same as above | Ar/O₂=97/3 3.9 Pa | Same as above | Same as above | Same as above | Same as above |
| 48 | Same as above | Same as above | Ar/O₂=95/5 3.9 Pa | Same as above | Same as above | Same as above | Same as above |
| 49 | Same as above | Low purity TiOₓ | Ar/O₂=99/1 3.9 Pa | Same as above | Same as above | Same as above | Same as above |
| 50 | Same as above | Same as above | Ar/O₂=97/3 3.9 Pa | Same as above | Same as above | Same as above | Same as above |
| 51 | Same as above | Same as above | Ar/O₂=95/5 3.9 Pa | Same as above | Same as above | Same as above | Same as above |

**TABLE 8**

| | Undercoating film (SiO₂ film) | Overcoating (SiO₂ film) | |
|---|---|---|---|
| Example No. | Film thickness (nm) | Film thickness (nm) | Pressure for deposition (Pa) |
| 38 | Nil | Nil | Nil |
| 39 | Same as above | Same as above | Same as above |
| 40 | Same as above | Same as above | Same as above |
| 41 | Same as above | Same as above | Same as above |
| 42 | Same as above | Same as above | Same as above |
| 43 | Same as above | Same as above | Same as above |
| 44 | Same as above | Same as above | Same as above |
| 45 | Same as above | Same as above | Same as above |
| 46 | Same as above | Same as above | Same as above |
| 47 | Same as above | Same as above | Same as above |
| 48 | Same as above | Same as above | Same as above |
| 49 | Same as above | Same as above | Same as above |
| 50 | Same as above | Same as above | Same as above |
| 51 | Same as above | Same as above | Same as above |

**TABLE 9**

| Example No. | Hydrophilicity | Anti-fogging property | Crystal structure | Gas decomposing property | Light-responsive current ratio |
|---|---|---|---|---|---|
| 38 | ○ | Δ | Anatase | ○ | 156000 |
| 39 | ○ | Δ | Same as above | ○ | 33500 |
| 40 | ○ | Δ | Same as above | ○ | 11100 |
| 41 | ○ | Δ | Same as above | ○ | 28900 |
| 42 | ○ | Δ | Same as above | ○ | 52200 |
| 43 | ○ | Δ | Same as above | ○ | 17700 |
| 44 | ○ | Δ | Same as above | ○ | 9170 |
| 45 | × | × | Same as above | × | 600 |
| 46 | ○ | Δ | Same as above | ○ | 33100 |
| 47 | ○ | Δ | Same as above | ○ | 27100 |
| 48 | Δ | Δ | Same as above | Δ | 3540 |
| 49 | × | × | Non- crystalline | × | 0.99 |
| 50 | × | × | Same as above | × | 1.01 |
| 51 | × | × | Same as above | × | 1.71 |
| 52 | ○ | ○ | Anatase | ○ | 45500 |
| 53 | ○ | ○ | Same as above | ○ | 38900 |

From the above evaluation results, the following results are obtainable.
(1) By firing, under specific conditions, a Ti oxide film formed by a sputtering method under specific conditions by using a high purity TiOₓ target, a Ti oxide film having a high visible light-responsive photocatalytic property, can be obtained. If a low purity TiOₓ target is used, it is impossible to obtain a visible light-responsive photocatalytic property (Examples 1 to 25, and Examples 49 to 51).
(2) Further, not only in a case where the sputtering gas is composed solely of a rare gas, but also in a case where a nitrogen gas is also introduced, the Ti oxide film exhibits a high visible light-responsive photocatalytic property.
(3) Further, with a film not subjected to firing after the deposition, even if deposition is carried out by using a high purity TiOₓ target, no substantial gas decomposing property can be obtained (Examples 26 to 31).
(4) The film thickness is not particularly limited, and within a range of from 10 to 250 nm, the film has a high visible light-responsive photocatalytic property.
(5) In a case where a glass substrate containing an alkali metal is employed, by forming an undercoating film, it is possible to prevent diffusion of the alkali metal from the glass substrate to the Ti oxide film, whereby a high visible light-responsive photocatalytic property can be secured (Examples 32 to 34).
(6) In a case where an overcoating is formed, by adjusting the pressure for deposition to be at least 0.5 Pa, it is possible to reduce a damage to the Ti oxide film during the deposition and to maintain a high visible light-responsive photocatalytic property of the Ti oxide film (Example 35).
(7) The atmosphere, temperature and time for firing the Ti oxide film are important elements to develop the visible light-responsive photocatalytic property (Examples 36 and 37).
(8) As the residual gas pressure during deposition of the Ti oxide film is lower, i.e. as the vacuum degree is higher, it is possible to obtain a higher visible light-responsive photocatalytic property (Examples 38 to 41).
(9) As the discharge power for the Ti oxide film is lower, it is possible to obtain a higher visible light-responsive photocatalytic property (Examples 42 to 45).
(10) Further, not only in a case where the sputtering gas is solely composed of a rare gas but also in a case where an oxygen gas is also introduced, the Ti oxide film exhibits a high visible light-responsive photocatalytic property (Examples 46 to 48).

### INDUSTRIAL APPLICABILITY

The Ti oxide film of the present invention has a high visible light-responsive photocatalytic property and is excellent in transparency, and thus it is useful as a film for glass for vehicles or buildings where UV light is hardly transmitted.

## Claims

1. A Ti oxide film formed on a substrate, **characterized in that** when a voltage is applied to the Ti oxide film while the Ti oxide film is irradiated with light of a xenon lamp having a luminance of 100 mW/cm² and having ultraviolet light of less than 400 nm cutoff, the electric current value is at least 1,000 times the electric current value when the same voltage as said voltage is applied to the Ti oxide film in a dark place.

2. A Ti oxide film formed on a substrate, **characterized in that** the Ti oxide film has a crystal structure of anatase type, the surface layer of the Ti oxide film is TiO₂, the interior of the Ti oxide film is TiOₓ, and the total of contents of titanium, nitrogen and oxygen in the Ti oxide film is at least 99.0 mass%.

3. The Ti oxide film according to Claim 1 or 2, wherein an overcoating is formed on the Ti oxide film formed on the substrate.

4. The Ti oxide film according to Claim 1, 2 or 3, wherein the thickness of the Ti oxide film is from 5 to 600 nm.

5. The Ti oxide film according to Claim 2, wherein the surface layer of the Ti oxide film is within a range of from 3 to 20 nm from the surface of the film.

6. The Ti oxide film according to any one of Claims 1 to 5, wherein the absorbance of the Ti oxide film at a wavelength of 400 nm is from 0.3 to 40%.

7. The Ti oxide film according to any one of Claims 1 to 6, wherein the total of contents of titanium and oxygen in the Ti oxide film is at least 99.0 mass%.

8. The Ti oxide film according to any one of Claims 1 to 7, wherein an undercoating film is formed between the Ti oxide film and the substrate.

9. The Ti oxide film according to any one of Claims 1 to 8, wherein the substrate is a glass substrate.

10. The Ti oxide film according to Claim 9, wherein the glass substrate is UV screening glass.

11. The Ti oxide film according to any one of Claims 1 to 10, wherein the Ti oxide film is formed on the inside surface of glass for vehicles.

12. A Ti oxide film-coated substrate which is a substrate having the Ti oxide film as defined in any one of Claims 1 to 10 formed on the surface.

13. A process for producing a Ti oxide film which comprises forming on a substrate a Ti oxide film by a sputtering method in an atmosphere of at least one gas selected from the group consisting of a rare gas, a nitrogen-containing gas and an oxygen-containing gas by means of a sputtering target composed of TiOₓ (1<x<2) wherein the total of contents of titanium and oxygen is at least 99.0 mass%, and then firing the Ti oxide film in the presence of oxygen at a temperature of from 400 to 750°C for from 1 to 28 minutes.

14. The process for producing a Ti oxide film according to Claim 13, wherein the pressure during the deposition of the Ti oxide film is from 1.5 to 6 Pa.

15. A process for producing a Ti oxide film which comprises forming a Ti oxide film on a substrate by a sputtering method in an atmosphere of at least one gas selected from the group consisting of a rare gas, a nitrogen-containing gas and an oxygen-containing gas by means of a sputtering target composed of TiOₓ (1<x<2) wherein the total of contents of titanium and oxygen is at least 99.0 mass%, then forming a Si oxide film by a sputtering method under a deposition pressure of at least 1.0 Pa, followed by firing in the presence of oxygen at a temperature of from 400 to 750°C for from 1 to 28 minutes.
